(19) Europäisches Patentamt
European Patent Office
Office européen des brevets

(11) **EP 4 510 002 A1**

(12) **EUROPEAN PATENT APPLICATION**
published in accordance with Art. 153(4) EPC

(43) Date of publication:
**19.02.2025 Bulletin 2025/08**

(21) Application number: **22941510.4**

(22) Date of filing: **07.12.2022**

(51) International Patent Classification (IPC):
**G06F 16/22** (2019.01)    **H03M 7/30** (2006.01)

(52) Cooperative Patent Classification (CPC):
**G06F 16/22; H03M 7/30**

(86) International application number:
**PCT/CN2022/137287**

(87) International publication number:
**WO 2023/216575 (16.11.2023 Gazette 2023/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **11.05.2022 RU 2022112514**

(71) Applicant: **Huawei Technologies Co., Ltd.
Shenzhen, Guangdong 518129 (CN)**

(72) Inventors:
• **JI, Dedong**
  **Shenzhen, Guangdong 518129 (CN)**
• **NIKOLAI, Kovrizhnykh**
  **Shenzhen, Guangdong 518129 (CN)**
• **WANG, Jianpeng**
  **Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **DATA PAGE PROCESSING METHOD AND APPARATUS THEREFOR**

(57)    A data page processing method and apparatus are disclosed. The method includes: obtaining a second data page based on a first data page (S210); and compressing the second data page to obtain a compressed data page (S220), where the first data page includes first data stored in a row-based manner and a first group of offsets, and the first group of offsets indicates an offset of each row of data in the first data; and the second data page includes second data stored in a row-based manner and a second group of offsets, the second group of offsets indicates an offset of each row of data in the second data, the second data is data obtained by performing preprocessing on the first data, the second group of offsets is a group of offsets obtained by performing the preprocessing on the first group of offsets, and the preprocessing includes byte-level-based row-column conversion. In the data page processing method, a compression ratio is high, and compression time consumed is basically the same as that in a conventional compression method.

<u>200</u>

S210: Obtain a second data page based on a first data page

S220: Compress the second data page to obtain a compressed data page

**FIG. 1**

**Description**

This application claims priority to Russian Patent Application No. 2022112514, filed with the Federal Service for Intellectual Property on May 11, 2022 and entitled "DATA PAGE PROCESSING METHOD AND APPARATUS", which is incorporated herein by reference in its entirety.

**TECHNICAL FIELD**

Embodiments of this application relate to the field of information technologies, and more specifically, to a data page processing method and apparatus.

**BACKGROUND**

A data compression technology can save storage space, and also increase a data transmission rate, and therefore has been widely applied to the field of information technologies.

Currently, conventional data compression is generally implemented by using a dictionary compression algorithm, a prefix compression algorithm, or a general compression algorithm (for example, zlib, lz4, or zstd). However, data distribution characteristics are not taken into account in these compression algorithms. As a result, a compression ratio is low.

**SUMMARY**

Embodiments of this application provide a data page processing method and apparatus. In the data page processing method, a compression ratio (or a decompression ratio) is high, and compression time consumed (or decompression time consumed) is basically the same as that in a conventional compression (or decompression) method.

According to a first aspect, a data page processing method is provided, and includes: obtaining a second data page based on a first data page; and compressing the second data page to obtain a compressed data page, where the first data page includes first data stored in a row-based manner and a first group of offsets, and the first group of offsets indicates an offset of each row of data in the first data; and the second data page includes second data stored in a row-based manner and a second group of offsets, the second group of offsets indicates an offset of each row of data in the second data, the second data is data obtained by performing preprocessing on the first data, the second group of offsets is a group of offsets obtained by performing the preprocessing on the first group of offsets, and the preprocessing includes byte-level-based row-column conversion.

In embodiments of this application, the byte-level-based row-column conversion is performed on the data that is stored in the first data page and that is stored in the row-based manner, that is, the data stored in the row-based manner is converted into data stored in a column-based manner in an ordered reversible manner, so that the data is updated in place in the data page. Then, the converted second data page is compressed. However, because the rows of data stored in the obtained second data page are similar, repetitive, and regular, a compression ratio of compressing the second data page is higher than a compression ratio of directly compressing the first data page. This improves a compression ratio of a data page. In addition, compression time consumed in embodiments of this application is basically the same as that in the conventional compression method.

With reference to the first aspect, in some implementations of the first aspect, the obtaining a second data page based on a first data page includes: separately obtaining the first data and the first group of offsets from the first data page; performing the preprocessing on the first data by bytes to obtain the second data; performing the preprocessing on the first group of offsets by bytes to obtain the second group of offsets; and obtaining the second data page based on the second data and the second group of offsets.

With reference to the first aspect, in some implementations of the first aspect, the first data page includes a first row data part and a first directory part, the first row data part is used to store the first data, and the first directory part is used to store the first group of offsets; and the obtaining the second data page based on the second data and the second group of offsets includes: updating the first data stored in the first row data part to the second data, and updating the first group of offsets stored in the first directory part to the second group of offsets, to obtain the second data page.

With reference to the first aspect, in some implementations of the first aspect, the performing the preprocessing on the first data by bytes to obtain the second data includes: obtaining a start point and an end point of offsets of the first data; obtaining, based on the start point and the end point of the offsets of the first data and a unit offset length of the first group of offsets, a quantity M of offsets included in the first group of offsets; removing an invalid offset from the M offsets to obtain N offsets, where N is less than or equal to M, and both N and M are positive integers; arranging the N offsets in ascending order to obtain the sorted N offsets; dividing the first row data part into N regions based on the sorted N offsets, and obtaining a length of each row of data in the first data, where an amount of data in an $n^{th}$ region of the N regions is a length of an $n^{th}$ row of data in the first data; and sequentially obtaining, in an arrangement order of the N offsets from the N regions, data corresponding to a byte i as data in a row i and a column N of the second data, where a value of i is sequentially obtained from 1 to L1, i is a positive integer, L1 is a maximum row length of the first data, and the arrangement order of the N offsets is an arrangement order of the N offsets in ascending order or an arrangement order of the N offsets in the first group of offsets; and the performing the preprocessing on the first group of offsets by bytes to obtain the second group of offsets includes: performing the preprocessing on the N offsets in the first group of offsets by bytes to obtain the second group of offsets.

With reference to the first aspect, in some implementations of the first aspect, before the sequentially obtaining, in an arrangement order of the N offsets from the N regions, data corresponding to a byte i as data in a row i and a column N of the second data, the method further includes: determining that a difference between lengths of rows of data in the first data is less than or equal to a first threshold.

In embodiments of this application, when it is determined that the difference between the lengths of the rows of data in the first data is less than or equal to the third threshold, the data corresponding to the byte i is sequentially obtained in the arrangement order of the N offsets from the N regions as the data in the row i and the column N of the second data. In this way, the byte-level-based row-column conversion is performed on the first data only when the difference between the lengths of the rows of data in the first data is small, and a waste of resources can be avoided.

With reference to the first aspect, in some implementations of the first aspect, the preprocessing further includes byte-level-based differential processing, and the differential processing includes differential processing between column data.

In embodiments of this application, more repetitive data can be produced after the byte-level-based differential processing is performed between column data. This can fully use data structure characteristics, further improve a data repetition degree and regularity, and improve a compression ratio of the data page.

With reference to the first aspect, in some implementations of the first aspect, the performing the preprocessing on the first data by bytes to obtain the second data includes: performing the row-column conversion on the first data by bytes to obtain third data; and performing differential processing on data in adjacent columns in a row a1 of the third data by bytes to obtain the second data, where $1 \leq a1 \leq a2$, both a1 and a2 are positive integers, and a2 is equal to a maximum row length of the first data or a2 is equal to a minimum row length of the first data; and the performing the preprocessing on the first group of offsets by bytes to obtain the second group of offsets includes: performing the row-column conversion on the first group of offsets by bytes to obtain a third group of offsets; and performing differential processing on data in adjacent columns in a row b1 of the third group of offsets by bytes to obtain the second group of offsets, where $1 \leq b1 \leq b2$, both b1 and b2 are positive integers, and b2 is equal to a maximum row length of the first group of offsets or b2 is equal to a minimum row length of the first group of offsets.

With reference to the first aspect, in some implementations of the first aspect, the performing the row-column conversion on the first data by bytes to obtain third data includes: obtaining a start point and an end point of offsets of the first data; obtaining, based on the start point and the end point of the offsets of the first data and a unit offset length of the first group of offsets, a quantity M of offsets included in the first group of offsets; removing an invalid offset from the M offsets to obtain N offsets, where N is less than or equal to M, and both N and M are positive integers; arranging the N offsets in ascending order to obtain the sorted N offsets; dividing the first row data part into N regions based on the sorted N offsets, and obtaining a length of each row of data in the first data, where an amount of data in an $n^{th}$ region of the N regions is a length of an $n^{th}$ row of data in the first data; and sequentially obtaining, in an arrangement order of the N offsets from the N regions, data corresponding to a byte i as data in a row i and a column N of the third data, where a value of i is sequentially obtained from 1 to L1, i is a positive integer, L1 is a maximum row length of the first data, and the arrangement order of the N offsets is an arrangement order of the N offsets in ascending order or an arrangement order of the N offsets in the first group of offsets; and the performing the row-column conversion on the first group of offsets by bytes to obtain a third group of offsets includes: performing the row-column conversion on the N offsets in the first group of offsets by bytes to obtain the third group of offsets.

With reference to the first aspect, in some implementations of the first aspect, before the sequentially obtaining, in an arrangement order of the N offsets from the N regions, data corresponding to a byte i as data in a row i and a column N of the third data, the method further includes: determining that a difference between lengths of rows of data in the first data is less than or equal to a first threshold.

In embodiments of this application, when it is determined that the difference between the lengths of the rows of data in the first data is less than or equal to the first threshold, the data corresponding to the byte i is sequentially obtained in the arrangement order of the N offsets from the N regions as the data in the row i and the column N of the third data. In this way, the byte-level-based row-column conversion is performed on the first data only when the difference between the lengths of the rows of data in the first data is small, and a waste of resources can be avoided.

With reference to the first aspect, in some implementations of the first aspect, before the dividing the first row data part into N regions based on the N offsets, the method further includes: determining that N is less than or equal to a second threshold.

In embodiments of this application, when it is determined that N is less than or equal to the second threshold, the first row data part is divided into the N regions based on the N offsets. In this way, the byte-level-based row-column conversion is performed on the first data only when a quantity of rows of the first data is small, and a waste of resources can be avoided.

With reference to the first aspect, in some implementations of the first aspect, the method further includes: reorganizing a plurality of consecutive third data pages of a same structure to obtain the first data page, where the third data page includes fourth data stored in a row-based manner and a fourth group of offsets, the fourth group of offsets indicates an offset of each row of data in the fourth data, the first data includes a plurality of pieces of fourth data corresponding to the plurality of third data pages, maximum row lengths of the plurality of pieces of fourth data are the same, and the first group of offsets includes a plurality of fourth groups of offsets corresponding to the plurality of third data pages.

In embodiments of this application, before the byte-level-based row-column conversion is performed on the data page, a plurality of consecutive data pages of a same structure may be reorganized to obtain one data page. This can fully use data page structure characteristics, reorganize the plurality of data pages that are highly similar into one data page, and further improve a compression ratio of the data page. In addition, compression time consumed is basically the same as the compression time consumed in the conventional compression method.

With reference to the first aspect, in some implementations of the first aspect, the reorganizing a plurality of consecutive third data pages of a same structure to obtain the first data page includes: separately obtaining the plurality of pieces of fourth data and the plurality of fourth groups of offsets that correspond to the plurality of third data pages; separately arranging the plurality of pieces of fourth data in a target order to obtain the first data, and separately arranging the plurality of fourth groups of offsets in the target order to obtain the first group of offsets, where the target order is an arrangement order of the plurality of third data pages; and separately storing the first data and the first group of offsets into the first data page.

With reference to the first aspect, in some implementations of the first aspect, the first data page includes information indicating that reorganization is performed on the first data page.

With reference to the first aspect, in some implementations of the first aspect, the second data page includes information indicating that the preprocessing is performed on the second data page.

With reference to the first aspect, in some implementations of the first aspect, the method further includes: decompressing the compressed data page to obtain the second data page; and obtaining the first data page based on the second data page, where the first data is data obtained by performing the preprocessing on the second data, and the first group of offsets is a group of offsets obtained by performing the preprocessing on the second group of offsets.

In embodiments of this application, because the rows of data stored in the second data page are similar, repetitive, and regular, a decompression ratio of decompressing the second data page is high. This improves a decompression ratio of a data page. In addition, decompression time consumed in embodiments of this application is basically the same as that in the conventional decompression method.

With reference to the first aspect, in some implementations of the first aspect, the obtaining the first data page based on the second data page includes: separately obtaining the second data and the second group of offsets from the second data page; performing the preprocessing on the second group of offsets by bytes to obtain the first group of offsets; performing the preprocessing on the second data by bytes based on the first group of offsets to obtain the first data; and obtaining the first data page based on the first data and the first group of offsets.

With reference to the first aspect, in some implementations of the first aspect, the second data page includes a second row data part and a second directory part, the second row data part is used to store the second data, and the second directory part is used to store the second group of offsets; and the obtaining the first data page based on the first data and the first group of offsets includes: updating the second data stored in the second row data part to the first data, and updating the second group of offsets stored in the second directory part to the first group of offsets, to obtain the first data page.

With reference to the first aspect, in some implementations of the first aspect, the performing the preprocessing on the second group of offsets by bytes to obtain the first group of offsets includes: performing the preprocessing on the second group of offsets by bytes based on a unit offset length of the second group of offsets to obtain the first group of offsets; and the performing the preprocessing on the second data by bytes based on the first group of offsets to obtain the first data includes: removing an invalid offset from the first group of offsets to obtain a fifth group of offsets, where the fifth group of offsets includes P offsets; arranging the P offsets in ascending order, to obtain the P sorted offsets; creating P regions based on the sorted P offsets, and obtaining a length of each row of data in the first data, where the P regions one-to-one correspond to the P offsets; and sequentially reading, from the second row data part, data corresponding to R bytes, and sequentially storing data corresponding to a byte $p$ in the R bytes into data corresponding to a byte $q$ in an $s^{th}$ region in the P regions, to complete a $q^{th}$ time of data reading/writing, where $p$ is a positive integer, a value of $p$ is obtained from 1 to R, R is a quantity of regions that are not fully written with data in the P regions, when the $s^{th}$ region is fully written with data, an amount of data in the $s^{th}$ region is a length of an $s^{th}$ row of data in the first data, $s$ is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the updating the second data stored in the second row data part to the first data includes: sequentially overwriting the second data stored in the second row data part with the data in the P regions.

With reference to the first aspect, in some implementations of the first aspect, before the sequentially reading, from the second row data part, data corresponding to P bytes, and sequentially storing data corresponding to a byte p in the P bytes into data corresponding to a byte q in an $s^{th}$ region, to complete a $q^{th}$ time of data reading/writing, the method further includes: determining that a difference between lengths of the rows of data in the first data is less than or equal to a third threshold.

In embodiments of this application, when it is determined that the difference between the lengths of the rows of data in the first data is less than or equal to the third threshold, the data corresponding to the P bytes is sequentially read from the second row data part, and the data corresponding to the byte p in the P bytes is sequentially stored into the data corresponding to the byte q in the $s^{th}$ region, to complete the $q^{th}$ time of data reading/writing. In this way, the byte-level-based row-column conversion is performed on the second data only when the difference between the lengths of the rows of data in the first data is small, and a waste of resources can be avoided.

With reference to the first aspect, in some implementations of the first aspect, the preprocessing further includes byte-level-based accumulation processing, and the accumulation processing includes accumulation between column data.

With reference to the first aspect, in some implementations of the first aspect, the performing the preprocessing on the second group of offsets by bytes to obtain the first group of offsets includes: accumulating data in adjacent columns in a row c1 of the second group of offsets by bytes to obtain a third group of offsets, where $1 \leq c1 \leq c2$, both c1 and c2 are positive integers, and c2 is equal to a maximum row length of the second group of offsets or c2 is equal to a minimum row length of the second group of offsets; and performing the row-column conversion on the third group of offsets by bytes to obtain the first group of offsets; and the performing the preprocessing on the second data by bytes based on the first group of offsets to obtain the first data includes: accumulating data in adjacent columns in a row d1 of the second data by bytes to obtain the third data, where $1 \leq d1 \leq d2$, both d1 and d2 are positive integers, and d2 is equal to a maximum row length of the second data or d2 is equal to a minimum row length of the second data; and performing the row-column conversion on the third data by bytes based on the first group of offsets to obtain the first data.

With reference to the first aspect, in some implementations of the first aspect, the performing the row-column conversion on the third group of offsets by bytes to obtain the first group of offsets includes: performing the row-column conversion on the third group of offsets by bytes based on a unit offset length of the third group of offsets to obtain the first group of offsets; the performing the row-column conversion on the third data by bytes based on the first group of offsets to obtain the first data includes: removing an invalid offset from the first group of offsets to obtain a fifth group of offsets, where the fifth group of offsets includes P offsets; arranging the P offsets in ascending order, to obtain the P sorted offsets; creating P regions based on the sorted P offsets, and obtaining a length of each row of data in the first data, where the P regions one-to-one correspond to the P offsets; and sequentially reading, from the third data, data corresponding to R bytes, and sequentially storing data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the updating the second data stored in the second row data part to the first data includes: sequentially overwriting the second data stored in the second row data part with the data in the P regions.

With reference to the first aspect, in some implementations of the first aspect, before the sequentially reading, from the second row data part, data corresponding to P bytes, and sequentially storing data corresponding to a byte p in the P bytes into data corresponding to a byte q in an $s^{th}$ region, to complete a $q^{th}$ time of data reading/writing, the method further includes: determining that a difference between lengths of the rows of data in the first data is less than or equal to a third threshold.

In embodiments of this application, when it is determined that the difference between the lengths of the rows of data in the first data is less than or equal to the third threshold, the data corresponding to the P bytes is sequentially read from the second row data part, and the data corresponding to the byte p in the P bytes is sequentially stored into the data corresponding to the byte q in the $s^{th}$ region, to complete the $q^{th}$ time of data reading/writing. In this way, the byte-level-based row-column conversion is performed on the third data only when the difference between the lengths of the rows of data in the first data is small, and a waste of resources can be avoided.

With reference to the first aspect, in some implementations of the first aspect, before the creating P regions based on the sorted P offsets, and obtaining a length of each row of data in the first data, the method further includes: determining that P is less than or equal to a fourth threshold.

In embodiments of this application, when it is determined that P is less than or equal to the fourth threshold, the P regions are created based on the sorted P offsets. In this way, the byte-level-based row-column conversion is performed on the third data only when a quantity of rows of the first data is small, and a waste of resources can be avoided.

With reference to the first aspect, in some implementations of the first aspect, the method further includes: splitting the first data page to obtain the plurality of third data pages.

With reference to the first aspect, in some implementations of the first aspect, the splitting the first data page to obtain the plurality of third data pages includes: obtaining start points and end points of fourth data in the plurality of third data pages and start points and end points of the fourth groups of offsets in the plurality of third data pages; obtaining the plurality of pieces of fourth data from the first data page based on the start points and the end points of the plurality of pieces of fourth data, and obtaining the plurality of fourth groups of offsets from the first data page based on the start points and the end points of the plurality of fourth groups of offsets; and separately storing the plurality of pieces of fourth data and the plurality of fourth groups of offsets into the plurality of third data pages.

With reference to the first aspect, in some implementations of the first aspect, the first data page includes the information indicating that the reorganization is performed on the first data page.

According to a second aspect, a data page processing method is provided, and includes: decompressing a compressed data page to obtain a second data page; and obtaining a first data page based on the second data page, where the second data page includes second data stored in a row-based manner and a second group of offsets, the second group of offsets indicates an offset of each row of data in the second data, the first data page include first data stored in a row-based manner and a first group of offsets, the first group of offsets indicates an offset of each row of data in the first data, the first data is data after preprocessing on the second data, and the first group of offsets is a group of offset after the preprocessing on the second group of offsets.

In embodiments of this application, because the rows of data stored in the second data page are similar, repetitive, and regular, a decompression ratio of decompressing the second data page is high. This improves a decompression ratio of a data page. In addition, decompression time consumed in embodiments of this application is basically the same as that in the conventional decompression method.

With reference to the second aspect, in some implementations of the second aspect, the obtaining a first data page based on the second data page includes: separately obtaining the second data and the second group of offsets from the second data page; performing preprocessing on the second group of offsets by bytes to obtain the first group of offsets; performing the preprocessing on the second data by bytes based on the first group of offsets to obtain the first data; and obtaining the first data page based on the first data and the first group of offsets.

With reference to the second aspect, in some implementations of the second aspect, the second data page includes a second row data part and a second directory part, the second row data part is used to store the second data, and the second directory part is used to store the second group of offsets; and the obtaining the first data page based on the first data and the first group of offsets includes: updating the second data stored in the second row data part to the first data, and updating the second group of offsets stored in the second directory part to the first group of offsets, to obtain the first data page.

With reference to the second aspect, in some implementations of the second aspect, the performing preprocessing on the second group of offsets by bytes to obtain the first group of offsets includes: performing the preprocessing on the second group of offsets by bytes based on a unit offset length of the second group of offsets to obtain the first group of offsets; and the performing the preprocessing on the second data by bytes based on the first group of offsets to obtain the first data includes: removing an invalid offset from the first group of offsets to obtain a fifth group of offsets, where the fifth group of offsets includes P offsets; arranging the P offsets in ascending order, to obtain the P sorted offsets; creating P regions based on the sorted P offsets, and obtaining a length of each row of data in the first data, where the P regions one-to-one correspond to the P offsets; and sequentially reading, from the second row data part, data corresponding to R bytes, and sequentially storing data corresponding to a byte $p$ in the R bytes into data corresponding to a byte $q$ in an $s^{th}$ region in the P regions, to complete a $q^{th}$ time of data reading/writing, where $p$ is a positive integer, a value of $p$ is obtained from 1 to R, R is a quantity of regions that are not fully written with data in the P regions, when the $s^{th}$ region is fully written with data, an amount of data in the $s^{th}$ region is a length of an $s^{th}$ row of data in the first data, $s$ is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of $q$ is obtained from 1 to L2, and L2 is a maximum row length of the first data; and the updating the second data stored in the second row data part to the first data includes: sequentially overwriting the second data stored in the second row data part with the data in the P regions.

With reference to the second aspect, in some implementations of the second aspect, before the sequentially reading, from the second row data part, data corresponding to P bytes, and sequentially storing data corresponding to a byte $p$ in the P bytes into data corresponding to a byte $q$ in an $s^{th}$ region, to complete a $q^{th}$ time of data reading/writing, the method further includes: determining that a difference between lengths of the rows of data in the first data is less than or equal to a third threshold.

In embodiments of this application, when it is determined that the difference between the lengths of the rows of data in the first data is less than or equal to the third threshold, the data corresponding to the P bytes is sequentially read from the second row data part, and the data corresponding to the byte p in the P bytes is sequentially stored into the data corresponding to the byte q in the $s^{th}$ region, to complete the $q^{th}$ time of data reading/writing. In this way, the byte-level-based row-column conversion is performed on the second data only when the difference between the lengths of the rows of data in the first data is small, and a waste of resources can be avoided.

With reference to the second aspect, in some implementations of the second aspect, the preprocessing further includes byte-level-based accumulation processing, and the accumulation processing includes accumulation between column data.

With reference to the second aspect, in some implementations of the second aspect, the performing preprocessing on the second group of offsets by bytes to obtain the first group of offsets includes: accumulating data in adjacent columns in a row c1 of the second group of offsets by bytes to obtain a third group of offsets, where $1 \leq c1 \leq c2$, both c1 and c2 are positive integers, and c2 is equal to a maximum row length of the second group of offsets or c2 is equal to a minimum row length of the second group of offsets; and performing row-column conversion on the third group of offsets by bytes to obtain the first group of offsets; and the performing the preprocessing on the second data by bytes based on the first group of offsets to obtain the first data includes: accumulating data in adjacent columns in a row d1 of the second data by bytes to obtain the third data, where $1 \leq d1 \leq d2$, both d1 and d2 are positive integers, and d2 is equal to a maximum row length of the second data or d2 is equal to a minimum row length of the second data; and performing the row-column conversion on the third data by bytes based on the first group of offsets to obtain the first data.

With reference to the second aspect, in some implementations of the second aspect, the performing row-column conversion on the third group of offsets by bytes to obtain the first group of offsets includes: performing the row-column conversion on the third group of offsets by bytes based on a unit offset length of the third group of offsets to obtain the first group of offsets; the performing the row-column conversion on the third data by bytes based on the first group of offsets to obtain the first data includes: removing an invalid offset from the first group of offsets to obtain a fifth group of offsets, where the fifth group of offsets includes P offsets; arranging the P offsets in ascending order, to obtain the P sorted offsets; creating P regions based on the sorted P offsets, and obtaining a length of each row of data in the first data, where the P regions one-to-one correspond to the P offsets; and sequentially reading, from the third data, data corresponding to R bytes, and sequentially storing data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the updating the second data stored in the second row data part to the first data includes: sequentially overwriting the second data stored in the second row data part with the data in the P regions.

With reference to the second aspect, in some implementations of the second aspect, before the sequentially reading, from the second row data part, data corresponding to P bytes, and sequentially storing data corresponding to a byte p in the P bytes into data corresponding to a byte q in an $s^{th}$ region, to complete a $q^{th}$ time of data reading/writing, the method further includes: determining that a difference between lengths of the rows of data in the first data is less than or equal to a third threshold.

In embodiments of this application, when it is determined that the difference between the lengths of the rows of data in the first data is less than or equal to the third threshold, the data corresponding to the P bytes is sequentially read from the second row data part, and the data corresponding to the byte p in the P bytes is sequentially stored into the data corresponding to the byte q in the $s^{th}$ region, to complete the $q^{th}$ time of data reading/writing. In this way, the byte-level-based row-column conversion is performed on the third data only when the difference between the lengths of the rows of data in the first data is small, and a waste of resources can be avoided.

With reference to the second aspect, in some implementations of the second aspect, before the creating P regions based on the sorted P offsets, and obtaining a length of each row of data in the first data, the method further includes: determining that P is less than or equal to a fourth threshold.

In embodiments of this application, when it is determined that P is less than or equal to the fourth threshold, the P regions are created based on the sorted P offsets. In this way, the byte-level-based row-column conversion is performed on the third data only when a quantity of rows of the first data is small, and a waste of resources can be avoided.

With reference to the second aspect, in some implementations of the second aspect, the method further includes: splitting the first data page to obtain a plurality of third data pages.

With reference to the second aspect, in some implementations of the second aspect, the splitting the first data page to obtain a plurality of third data pages includes: obtaining start points and end points of fourth data and start points and end points of fourth groups of offsets in the plurality of third data pages; obtaining a plurality of pieces of fourth data from the first data page based on the start points and the end points of the plurality of pieces of fourth data, and obtaining a plurality of fourth groups of offsets from the first data page based on the start points and the end points of the plurality of fourth groups of offsets; and separately storing the plurality of pieces of fourth data and the plurality of fourth groups of offsets into the plurality of third data pages.

With reference to the second aspect, in some implementations of the second aspect, the first data page includes information indicating that reorganization is performed on the first data page.

According to a third aspect, a data page processing apparatus is provided, and the apparatus includes a processing unit. The processing unit is configured to: obtain a second data page based on a first data page; and compress the second data page to obtain a compressed data page, where the first data page includes first data stored in a row-based manner and a first group of offsets, and the first group of offsets indicates an offset of each row of data in the first data; and the second data page includes second data stored in a row-based manner and a second group of offsets, the second group of offsets indicates an offset of each row of data in the second data, the second data is data obtained by performing preprocessing on the first data, the second group of offsets is a group of offsets obtained by performing the preprocessing on the first group of offsets, and the preprocessing includes byte-level-based row-column conversion.

In embodiments of this application, the processing unit in the data page processing apparatus performs the byte-level-based row-column conversion on the data that is stored in the first data page and that is stored in the row-based manner, that is, the data stored in the row-based manner is converted into data stored in a column-based manner in an ordered reversible manner, so that the data is updated in place in the data page. Then, the converted second data page is compressed. However, because the rows of data stored in the obtained second data page are similar, repetitive, and regular, a compression ratio of compressing the second data page is higher than a compression ratio of directly compressing the first data page. This improves a compression ratio of a data page. In addition, compression time consumed by the data page processing apparatus is basically the same as that in a conventional compression apparatus.

With reference to the third aspect, in some implementations of the third aspect, the processing unit is further specifically configured to: separately obtain the first data and the first group of offsets from the first data page; perform the preprocessing on the first data by bytes to obtain the second data; perform the preprocessing on the first group of offsets by bytes to obtain the second group of offsets; and obtain the second data page based on the second data and the second group of offsets.

With reference to the third aspect, in some implementations of the third aspect, the first data page includes a first row data part and a first directory part, the first row data part is used to store the first data, and the first directory part is used to store the first group of offsets; and the processing unit is further specifically configured to: update the first data stored in the first row data part to the second data, and update the first group of offsets stored in the first directory part to the second group of offsets, to obtain the second data page.

With reference to the third aspect, in some implementations of the third aspect, the processing unit is further specifically configured to: obtain a start point and an end point of offsets of the first data; obtain, based on the start point and the end point of the offsets of the first data and a unit offset length of the first group of offsets, a quantity M of offsets included in the first group of offsets; remove an invalid offset from the M offsets to obtain N offsets, where N is less than or equal to M, and both N and M are positive integers; arrange the N offsets in ascending order to obtain the sorted N offsets; divide the first row data part into N regions based on the sorted N offsets, and obtain a length of each row of data in the first data, where an amount of data in an $n^{th}$ region of the N regions is a length of an $n^{th}$ row of data in the first data; and sequentially obtain, in an arrangement order of the N offsets from the N regions, data corresponding to a byte i as data in a row i and a column N of the second data, where a value of i is sequentially obtained from 1 to L1, i is a positive integer, L1 is a maximum row length of the first data, and the arrangement order of the N offsets is an arrangement order of the N offsets in ascending order or an arrangement order of the N offsets in the first group of offsets; and the processing unit is further specifically configured to: perform the preprocessing on the N offsets in the first group of offsets by bytes to obtain the second group of offsets.

With reference to the third aspect, in some implementations of the third aspect, the processing unit is further configured to: before sequentially obtaining, in the arrangement order of the N offsets from the N regions, the data corresponding to the byte i as the data in the row i and the column N of the second data, determine that a difference between lengths of rows of data in the first data is less than or equal to a first threshold.

With reference to the third aspect, in some implementations of the third aspect, the preprocessing further includes byte-level-based differential processing, and the differential processing includes differential processing between column data.

With reference to the third aspect, in some implementations of the third aspect, the processing unit is further specifically configured to: perform the row-column conversion on the first data by bytes to obtain third data; and perform differential processing on data in adjacent columns in a row a1 of the third data by bytes to obtain the second data, where $1 \leq a1 \leq a2$, both a1 and a2 are positive integers, and a2 is equal to a maximum row length of the first data or a2 is equal to a minimum row length of the first data; and the processing unit is further specifically configured to: perform the row-column conversion on the first group of offsets by bytes to obtain a third group of offsets; and perform differential processing on data in adjacent columns in a row b1 of the third group of offsets by bytes to obtain the second group of offsets, where $1 \leq b1 \leq b2$, both b1 and b2 are positive integers, and b2 is equal to a maximum row length of the first group of offsets or b2 is equal to a minimum row length of the first group of offsets.

With reference to the third aspect, in some implementations of the third aspect, the processing unit is further specifically configured to: obtain a start point and an end point of offsets of the first data; obtain, based on the start point and the end point of the offsets of the first data and a unit offset length of the first group of offsets, a quantity M of offsets included in the first group of offsets; remove an invalid offset from the M offsets to obtain N offsets, where N is less than or equal to M, and both N and M are positive integers; arrange the N offsets in ascending order to obtain the sorted N offsets; divide the first row data part into N regions based on the sorted N offsets, and obtain a length of each row of data in the first data, where an amount of data in an $n^{th}$ region of the N regions is a length of an $n^{th}$ row of data in the first data; and sequentially obtain, in an arrangement order of the N offsets from the N regions, data corresponding to a byte i as data in a row i and a column N of the third data, where a value of i is sequentially obtained from 1 to L1, i is a positive integer, L1 is a maximum row length of the first data, and the arrangement order of the N offsets is an arrangement order of the N offsets in ascending order or an arrangement order of the N offsets in the first group of offsets; and the processing unit is further specifically configured to: perform the row-column conversion on the N offsets in the first group of offsets by bytes to obtain the third group of offsets.

With reference to the third aspect, in some implementations of the third aspect, the processing unit is further configured to: before sequentially obtaining, in the arrangement order of the N offsets from the N regions, the data corresponding to the byte i as the data in the row i and the column N of the third data, determine that a difference between lengths of rows of data in the first data is less than or equal to a first threshold.

With reference to the third aspect, in some implementations of the third aspect, the processing unit is further configured to: before dividing the first row data part into the N regions based on the N offsets, determine that N is less than or equal to a second threshold.

With reference to the third aspect, in some implementations of the third aspect, the processing unit is further configured to: reorganize a plurality of consecutive third data pages of a same structure to obtain the first data page, where the third data page includes fourth data stored in a row-based manner and a fourth group of offsets, the fourth group of offsets indicates an offset of each row of data in the fourth data, the first data includes a plurality of pieces of fourth data corresponding to the plurality of third data pages, maximum row lengths of the plurality of pieces of fourth data are the same, and the first group of offsets includes a plurality of fourth groups of offsets corresponding to the plurality of third data pages.

With reference to the third aspect, in some implementations of the third aspect, the processing unit is further specifically configured to: separately obtain the plurality of pieces of fourth data and the plurality of fourth groups of offsets that correspond to the plurality of third data pages; separately arrange the plurality of pieces of fourth data in a target order to obtain the first data, and separately arrange the plurality of fourth groups of offsets in the target order to obtain the first group of offsets, where the target order is an arrangement order of the plurality of third data pages; and separately store the first data and the first group of offsets into the first data page.

With reference to the third aspect, in some implementations of the third aspect, the first data page includes information indicating that reorganization is performed on the first data page.

With reference to the third aspect, in some implementations of the third aspect, the second data page includes information indicating that the preprocessing is performed on the second data page.

With reference to the third aspect, in some implementations of the third aspect, the processing unit is further configured to: decompress the compressed data page to obtain the second data page; and obtain the first data page based on the second data page, where the first data is data obtained by performing the preprocessing on the second data, and the first group of offsets is a group of offsets obtained by performing the preprocessing on the second group of offsets.

With reference to the third aspect, in some implementations of the third aspect, the processing unit is further specifically configured to: separately obtain the second data and the second group of offsets from the second data page; perform the preprocessing on the second group of offsets by bytes to obtain the first group of offsets; perform the preprocessing on the second data by bytes based on the first group of offsets to obtain the first data; and obtain the first data page based on the first data and the first group of offsets.

With reference to the third aspect, in some implementations of the third aspect, the second data page includes a second row data part and a second directory part, the second row data part is used to store the second data, and the second directory part is used to store the second group of offsets; and the processing unit is further specifically configured to: update the second data stored in the second row data part to the first data, and update the second group of offsets stored in the second directory part to the first group of offsets, to obtain the first data page.

With reference to the third aspect, in some implementations of the third aspect, the processing unit is further specifically configured to: perform the preprocessing on the second group of offsets by bytes based on a unit offset length of the second group of offsets to obtain the first group of offsets; the processing unit is further specifically configured to: remove an invalid offset from the first group of offsets to obtain a fifth group of offsets, where the fifth group of offsets includes P offsets; arrange the P offsets in ascending order, to obtain the P sorted offsets; create P regions based on the sorted P offsets, and obtain a length of each row of data in the first data, where the P regions one-to-one correspond to the P offsets; and sequentially read, from the second row data part, data corresponding to R bytes, and sequentially store data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the processing unit is further specifically configured to: sequentially overwrite the second data stored in the second row data part with the data in the P regions.

With reference to the third aspect, in some implementations of the third aspect, the processing unit is further specifically configured to: before sequentially reading, from the second row data part, the data corresponding to the P bytes, and sequentially storing the data corresponding to the byte p in the P bytes into the data corresponding to the byte q in the $s^{th}$ region, to complete the $q^{th}$ time of data reading/writing, determine that a difference between lengths of the rows of data in the first data is less than or equal to a third threshold.

With reference to the third aspect, in some implementations of the third aspect, the preprocessing further includes byte-level-based accumulation processing, and the accumulation processing includes accumulation between column data.

With reference to the third aspect, in some implementations of the third aspect, the processing unit is further specifically configured to: accumulate data in adjacent columns in a row c1 of the second group of offsets by bytes to obtain a third group of offsets, where 1≤c1≤c2, both c1 and c2 are positive integers, and c2 is equal to a maximum row length of the second group of offsets or c2 is equal to a minimum row length of the second group of offsets; and perform the row-column conversion on the third group of offsets by bytes to obtain the first group of offsets; and the processing unit is further specifically configured to: accumulate data in adjacent columns in a row d1 of the second data by bytes to obtain the third data, where 1≤d1≤d2, both d1 and d2 are positive integers, and d2 is equal to a maximum row length of the second data or d2 is equal to a minimum row length of the second data; and perform the row-column conversion on the third data by bytes based on the first group of offsets to obtain the first data.

With reference to the third aspect, in some implementations of the third aspect, the processing unit is further specifically configured to: perform the row-column conversion on the third group of offsets by bytes based on a unit offset length of the third group of offsets to obtain the first group of offsets; the processing unit is further specifically configured to: remove an invalid offset from the first group of offsets to obtain a fifth group of offsets, where the fifth group of offsets includes P offsets; arrange the P offsets in ascending order, to obtain the P sorted offsets; create P regions based on the sorted P offsets, and obtain a length of each row of data in the first data, where the P regions one-to-one correspond to the P offsets; and sequentially read, from the third data, data corresponding to R bytes, and sequentially store data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the processing unit is further specifically configured to: sequentially overwrite the second data stored in the second row data part with the data in the P regions.

With reference to the third aspect, in some implementations of the third aspect, the processing unit is further configured to: before sequentially reading, from the second row data part, the data corresponding to the P bytes, and sequentially storing the data corresponding to the byte p in the P bytes into the data corresponding to the byte q in the $s^{th}$ region, to complete the $q^{th}$ time of data reading/writing, determine that a difference between lengths of the rows of data in the first data is less than or equal to a third threshold.

With reference to the third aspect, in some implementations of the third aspect, the processing unit is further configured to: before creating the P regions based on the sorted P offsets, and obtaining the length of each row of data in the first data, determine that P is less than or equal to a fourth threshold.

With reference to the third aspect, in some implementations of the third aspect, the processing unit is further configured to: split the first data page to obtain the plurality of third data pages.

With reference to the third aspect, in some implementations of the third aspect, the processing unit is further specifically configured to: obtain start points and end points of the fourth data and start points and end points of the fourth groups of offsets in the plurality of third data pages; obtain the plurality of pieces of fourth data from the first data page based on the start points and the end points of the plurality of pieces of fourth data; obtain the plurality of fourth groups of offsets from the first data page based on the start points and the end points of the plurality of fourth groups of offsets; and separately store the plurality of pieces of fourth data and the plurality of fourth groups of offsets into the plurality of third data pages.

With reference to the third aspect, in some implementations of the third aspect, the first data page includes the information indicating that the reorganization is performed on the first data page.

According to a fourth aspect, a data page processing apparatus is provided, and the apparatus includes a processing unit. The processing unit is configured to: decompress a compressed data page to obtain a second data page; and obtain a first data page based on the second data page, where the second data page includes second data stored in a row-based manner and a second group of offsets, the second group of offsets indicates an offset of each row of data in the second data, the first data page include first data stored in a row-based manner and a first group of offsets, the first group of offsets indicates an offset of each row of data in the first data, the first data is data after preprocessing on the second data, and the first group of offsets is a group of offset after the preprocessing on the second group of offsets.

In embodiments of this application, because the rows of data stored in the second data page are similar, repetitive, and regular, a decompression ratio of decompressing the second data page by the processing unit in the data page processing apparatus is high. This improves a decompression ratio of a data page. In addition, compression time consumed by the data page processing apparatus is basically the same as that in a conventional decompression apparatus.

With reference to the fourth aspect, in some implementations of the fourth aspect, the processing unit is further specifically configured to: separately obtain the second data and the second group of offsets from the second data page; perform the preprocessing on the second group of offsets by bytes to obtain the first group of offsets; perform the preprocessing on the second data by bytes based on the first group of offsets to obtain the first data; and obtain the first data page based on the first data and the first group of offsets.

With reference to the fourth aspect, in some implementations of the fourth aspect, the second data page includes a second row data part and a second directory part, the second row data part is used to store the second data, and the second directory part is used to store the second group of offsets; and the processing unit is further specifically configured to: update the second data stored in the second row data part to the first data, and update the second group of offsets stored in the second directory part to the first group of offsets, to obtain the first data page.

With reference to the fourth aspect, in some implementations of the fourth aspect, the processing unit is further specifically configured to: perform the preprocessing on the second group of offsets by bytes based on a unit offset length of the second group of offsets to obtain the first group of offsets; the processing unit is further specifically configured to: remove an invalid offset from the first group of offsets to obtain a fifth group of offsets, where the fifth group of offsets includes P offsets; arrange the P offsets in ascending order, to obtain the P sorted offsets; create P regions based on the sorted P offsets, and obtain a length of each row of data in the first data, where the P regions one-to-one correspond to the P offsets; and sequentially read, from the second row data part, data corresponding to R bytes, and sequentially store data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the processing unit is further specifically configured to: sequentially overwrite the second data stored in the second row data part with the data in the P regions.

With reference to the fourth aspect, in some implementations of the fourth aspect, the processing unit is further specifically configured to: before sequentially reading, from the second row data part, the data corresponding to the P bytes, and sequentially storing the data corresponding to the byte p in the P bytes into the data corresponding to the byte q in the $s^{th}$ region, to complete the $q^{th}$ time of data reading/writing, determine that a difference between lengths of the rows of data in the first data is less than or equal to a third threshold.

With reference to the fourth aspect, in some implementations of the fourth aspect, the preprocessing further includes byte-level-based accumulation processing, and the accumulation processing includes accumulation between column data.

With reference to the fourth aspect, in some implementations of the fourth aspect, the processing unit is further specifically configured to: accumulate data in adjacent columns in a row c1 of the second group of offsets by bytes to obtain a third group of offsets, where 1≤c1≤c2, both c1 and c2 are positive integers, and c2 is equal to a maximum row length of the second group of offsets or c2 is equal to a minimum row length of the second group of offsets; and perform the row-column conversion on the third group of offsets by bytes to obtain the first group of offsets; and the processing unit is further specifically configured to: accumulate data in adjacent columns in a row d1 of the second data by bytes to obtain the third data, where 1≤d1≤d2, both d1 and d2 are positive integers, and d2 is equal to a maximum row length of the second data or d2 is equal to a minimum row length of the second data; and perform the row-column conversion on the third data by bytes based on the first group of offsets to obtain the first data.

With reference to the fourth aspect, in some implementations of the fourth aspect, the processing unit is further specifically configured to: perform the row-column conversion on the third group of offsets by bytes based on a unit offset length of the third group of offsets to obtain the first group of offsets; the processing unit is further specifically configured to: remove an invalid offset from the first group of offsets to obtain a fifth group of offsets, where the fifth group of offsets includes P offsets; arrange the P offsets in ascending order, to obtain the P sorted offsets; create P regions based on the sorted P offsets, and obtain a length of each row of data in the first data, where the P regions one-to-one correspond to the P offsets; and sequentially read, from the third data, data corresponding to R bytes, and sequentially store data corresponding to a byte p in the R bytes into data corresponding to a byte q in an $s^{th}$ region in the P regions, to complete a $q^{th}$ time of data reading/writing, where p is a positive integer, a value of p is obtained from 1 to R, R is a quantity of regions that are not fully written with data in the P regions, when the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data, a value of q is obtained from 1 to L2, and L2 is a maximum row length of the first data; and the processing unit is further specifically configured to: sequentially overwrite the second data stored in the second row data part with the data in the P regions.

With reference to the fourth aspect, in some implementations of the fourth aspect, the processing unit is further configured to: before sequentially reading, from the second row data part, the data corresponding to the P bytes, and sequentially storing the data corresponding to the byte p in the P bytes into the data corresponding to the byte q in the $s^{th}$ region, to complete the $q^{th}$ time of data reading/writing, determine that a difference between lengths of the rows of data in the first data is less than or equal to a third threshold.

With reference to the fourth aspect, in some implementations of the fourth aspect, the processing unit is further configured to: before creating the P regions based on the sorted P offsets, and obtaining the length of each row of data in the first data, determine that P is less than or equal to a fourth threshold.

With reference to the fourth aspect, in some implementations of the fourth aspect, the processing unit is further configured to: split the first data page to obtain a plurality of third data pages.

With reference to the fourth aspect, in some implementations of the fourth aspect, the processing unit is further specifically configured to: obtain start points and end points of fourth data and start points and end points of fourth groups of offsets in the plurality of third data pages; obtain the plurality of pieces of fourth data from the first data page based on the start points and the end points of the plurality of pieces of fourth data; obtain the plurality of fourth groups of offsets from the first data page based on the start points and the end points of the plurality of fourth groups of offsets; and separately store the plurality of pieces of fourth data and the plurality of fourth groups of offsets into the plurality of third data pages.

With reference to the fourth aspect, in some implementations of the fourth aspect, the first data page includes information indicating that reorganization is performed on the first data page.

According to a fifth aspect, a data page processing apparatus is provided, and the apparatus includes a processor and a memory. The memory is configured to store a computer program, and the processor is configured to execute the computer program stored in the memory, so that the apparatus performs the method in any possible implementation of the first aspect or the second aspect.

According to a sixth aspect, a computer-readable storage medium is provided. The computer-readable storage medium stores a computer program, and when the computer program is run on a computer, the computer is enabled to perform the method in any possible implementation of the first aspect or the second aspect.

According to a seventh aspect, a chip system is provided, and includes a processor, configured to invoke a computer program from a memory and run the computer program, so that an apparatus on which the chip system is installed performs the method in any possible implementation of the first aspect or the second aspect.

According to an eighth aspect, a computer program product including instructions is provided. When the computer program product runs on an apparatus, the apparatus is enabled to perform the method in any possible implementation of the first aspect or the second aspect.

**BRIEF DESCRIPTION OF DRAWINGS**

FIG. 1 is a schematic flowchart of an example of a data page compression method 200 according to an embodiment of this application;

FIG. 2 is a diagram of an example of a data page according to an embodiment of this application;

FIG. 3 to FIG. 6 each are a schematic flowchart of obtaining a second data page according to an embodiment of this application;

FIG. 7 is a diagram of an example of reorganizing a plurality of data pages according to an embodiment of this application;

FIG. 8 is a diagram of an example of compression performance of a conventional compression method and compression performance of a data page compression method according to an embodiment of this application;

FIG. 9 is a diagram of another example of compression performance of a conventional compression method and compression performance of a data page compression method according to an embodiment of this application;

FIG. 10 is a diagram of still another example of compression performance of a conventional compression method and compression performance of a data page compression method according to an embodiment of this application;
FIG. 11 is a diagram of still another example of compression performance of a conventional compression method and compression performance of a data page compression method according to an embodiment of this application;
FIG. 12 is a schematic flowchart of another example of a data page decompression method according to an embodiment of this application;
FIG. 13 is a diagram of an example of a second data reading/writing process according to an embodiment of this application;
FIG. 14 is a diagram of another example of a second data reading/writing process according to an embodiment of this application;
FIG. 15 is a block diagram of an example of a data page processing apparatus according to an embodiment of this application; and
FIG. 16 is a diagram of a structure of an example of a data page processing apparatus according to an embodiment of this application.

## DESCRIPTION OF EMBODIMENTS

A data compression technology can save storage space, and also increase a data transmission rate, and therefore has been widely applied to the field of information technologies.

For example, in transparent compression related to MySQL, all data in a single data page is first delivered to a data compression library before being flushed to a disk. The data compression library compresses the single data page based on a general compression algorithm (for example, zlib, lz4, or zstd), and then stores compressed data to an original address. Then, a hole punching technology of a file system (a file system feature, with a unit of hole punching is 4 K) is used to punch a hole in free space. However, in a Linux system, a unit of hole punching is 4 K. When a size of the data page is 32 K or 64 K, the data page does not support compression. A data page with a maximum size of 16 K supports such compression. Therefore, a maximum compression ratio is 4: 1.

For another example, in dictionary compression related to Oracle, a dictionary of row fields is created at a block level (data page concept), where the fields store references to dictionary elements. When the dictionary is updated, inserted, or deleted, whether to perform compression is controlled based on a threshold. However, the dictionary compression is a dictionary compression algorithm based on a storage block, and a symbol table is maintained in a page. All operations are based on transformation and inverse transformation performed on the symbol table, and therefore, implementation is complex. In addition, the dictionary compression is easily affected by data characteristics. If data is not highly repeated, a compression ratio is low.

For another example, DB2 supports a page-level compression dictionary algorithm and a table-level dictionary compression algorithm. Page-level and table-level dictionaries are stored in hidden rows of a table. Once a dictionary is created, the dictionary is not updated unless a field table is rebuilt. A compression ratio of this compression algorithm is strongly dependent on data characteristics. If initial data characteristics are poor and not representative, the compression algorithm does not have a good compression result.

Therefore, embodiments of this application provide a data page processing method. Data page processing may include data page compression and/or data page decompression. In the data page processing method, a compression ratio (or a decompression ratio) is high, and compression time consumed (or decompression time consumed) is basically the same as that in a conventional compression (or decompression) method.

An application scenario of the data page processing method provided in embodiments of this application may not be limited in embodiments of this application.

For example, the data page processing method provided in embodiments of this application is applied to but is not limited to an online production environment (for example, an online transaction processing (online transaction processing, OLTP) process), a database file compression backup storage scenario, and an active/standby logistics file replication scenario.

Therefore, embodiments of this application provide a data page compression method. In the data page compression method, a compression ratio is high, and compression time consumed is basically the same as that in a conventional compression method.

The following describes technical solutions in embodiments in this application with reference to accompanying drawings.

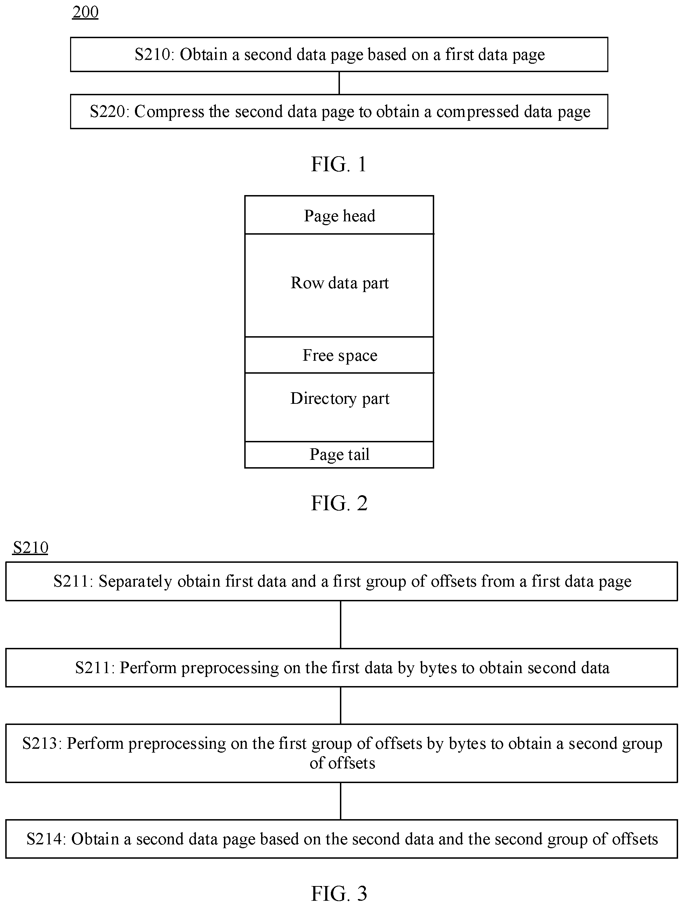

FIG. 1 is a schematic flowchart of an example of a data page compression method 200 according to an embodiment of this application.

For example, as shown in FIG. 1, the method 200 includes S210 and S220, and 5220 is performed after S210. S210 and S220 are described below in detail.

S210: Obtain a second data page based on a first data page.

The first data page includes first data stored in a row-based manner and a first group of offsets, and the first group of offsets indicates an offset of each row of data in the first data.

A form of an offset is not limited in this embodiment of this application. For example, an offset may correspond to a location (for example, a quantity of bytes) of a page head in a data page.

FIG. 2 is a diagram of an example of a data page according to an embodiment of this application. For example, as shown in FIG. 2, the data page may include a row data part and a directory part. The row data part is used to store data, and the directory part is used to store an offset of each row of data in the data stored in the row data part.

Optionally, in some embodiments, as shown in FIG. 2, the data page may further include a page head, a free space, and/or a page tail. The page head and/or the page tail are/is used to store information related to the data page. For example, the information related to the data page may include but is not limited to a number of the data page, a type of the data page, a quantity of rows of data stored in the row data part in the data page, a start point and an end point of the data stored in the row data part in the data page, a quantity of offsets stored in the directory part in the data page, and a start point and an end point of the offset stored in the directory part in the data page. The free space is mainly for expansion of the row data part and/or the page tail.

For example, the first data page may include a first page head, a first row data part, and a first directory part. The first page head is used to store information related to the first data page, the first row data part is used to store the first data, and the first directory part is used to store the first group of offsets.

Table 1 shows an example of first data. For example, as shown in Table 1, the first data includes three rows of data. The first row of data occupies three bytes, and data in the three bytes is sequentially a, b, and c. The second row of data occupies four bytes, and data in the four bytes is sequentially a, b, c, and d. The third row of data occupies five bytes, and data in the five bytes is sequentially a, b, c, d, and e.

**Table 1**

| Bytes / Rows | Byte 1 | Byte 2 | Byte 3 | Byte 4 | Byte 5 |
|---|---|---|---|---|---|
| Row 1 | a | b | c | | |
| Row 2 | a | b | c | d | |
| Row 3 | a | b | c | d | e |

Table 2 shows another example of first data. For example, as shown in Table 2, the first data includes three rows of data. The first row of data occupies five bytes, and data in the five bytes is sequentially a, b, c, d, and e. The second row of data occupies three bytes, and data in the three bytes is sequentially a, b, and c. The third row of data occupies four bytes, and data in the four bytes is sequentially a, b, c, and d.

**Table 2**

| Bytes / Rows | Byte 1 | Byte 2 | Byte 3 | Byte 4 | Byte 5 |
|---|---|---|---|---|---|
| Row 1 | a | b | c | d | e |
| Row 2 | a | b | c | | |
| Row 3 | a | b | c | d | |

An arrangement order of the offsets in the first group of offsets is not limited in this embodiment of this application.

In an example, the offsets in the first group of offsets are arranged in ascending order.

Table 3 shows an example of a first group of offsets. Offsets in the first group of offsets shown in Table 3 are arranged in ascending order, and the first group of offsets shown in Table 3 is offsets corresponding to the first data shown in Table 1.

For example, the first data shown in Table 1 includes the three rows. Therefore, the first group of offsets shown in Table 3 includes three offsets. A first offset (an offset of the first row of data in the first data) occupies two bytes, and data in the two bytes is sequentially 0x00 and 0x01. A second offset (an offset of the second row of data in the second data) occupies two bytes, and data in the two bytes is sequentially 0x00 and 0x04. A third offset (an offset of the third row of data in the third data) occupies two bytes, and data in the two bytes is sequentially 0x00 and 0x08.

**Table 3**

| Bytes / Rows | Byte 1 | Byte 2 |
|---|---|---|
| Row 1 | 0x00 | 0x01 |
| Row 2 | 0x00 | 0x04 |
| Row 3 | 0x00 | 0x08 |

In another example, the offsets in the first group of offsets are arranged out of order.

Table 4 shows another example of a first group of offsets. Offsets in the first group of offsets shown in Table 4 are arranged out of order, and the first group of offsets shown in Table 4 is offsets corresponding to the first data shown in Table 2.

For example, the first data shown in Table 4 includes the three rows. Therefore, the first group of offsets shown in Table 3 includes three offsets. A first offset (an offset of the second row of data in the first data) occupies two bytes, and data in the two bytes is sequentially 0x00 and 0x06. A second offset (an offset of the third row of data in the first data) occupies two bytes, and data in the two bytes is sequentially 0x00 and 0x09. A third offset (an offset of the first row of data in the first data) occupies two bytes, and data in the two bytes is sequentially 0x00 and 0x01.

**Table 4**

| Bytes / Rows | Byte 1 | Byte 2 |
|---|---|---|
| Row 1 | 0x00 | 0x06 |
| Row 2 | 0x00 | 0x09 |
| Row 3 | 0x00 | 0x01 |

It should be noted that, in this embodiment of this application, an example in which the offset is represented in a hexadecimal format is used for description, and this should not constitute a limitation on this embodiment of this application.

The second data page includes second data stored in a row-based manner and a second group of offsets, and the second group of offsets indicates an offset of each row of data in the second data.

The second data is data obtained by performing preprocessing on the first data, and the second group of offsets is a group of offsets obtained by performing the preprocessing on the first group of offsets. In other words, in S210, all parts of data included in the first data page are preprocessed to obtain the second data page.

In one example, the preprocessing includes only byte-level-based row-column conversion.

In another example, the preprocessing not only includes byte-level-based row-column conversion, but also includes byte-level-based differential processing. The differential processing includes differential processing between column data.

It should be noted that the byte-level-based row-column conversion may be understood as row-column conversion performed by bytes. The byte-level-based differential processing may be understood as differential processing performed by bytes.

In still another example, the preprocessing includes only byte-level-based differential processing.

For ease of description, a case in which the preprocessing includes only the byte-level-based row-column conversion is denoted as Case 1, a case in which the preprocessing includes not only the byte-level-based row-column conversion, but also includes the byte-level-based differential processing is denoted as Case 2, and a case in which the preprocessing includes only the byte-level-based differential processing is denoted as Case 3.

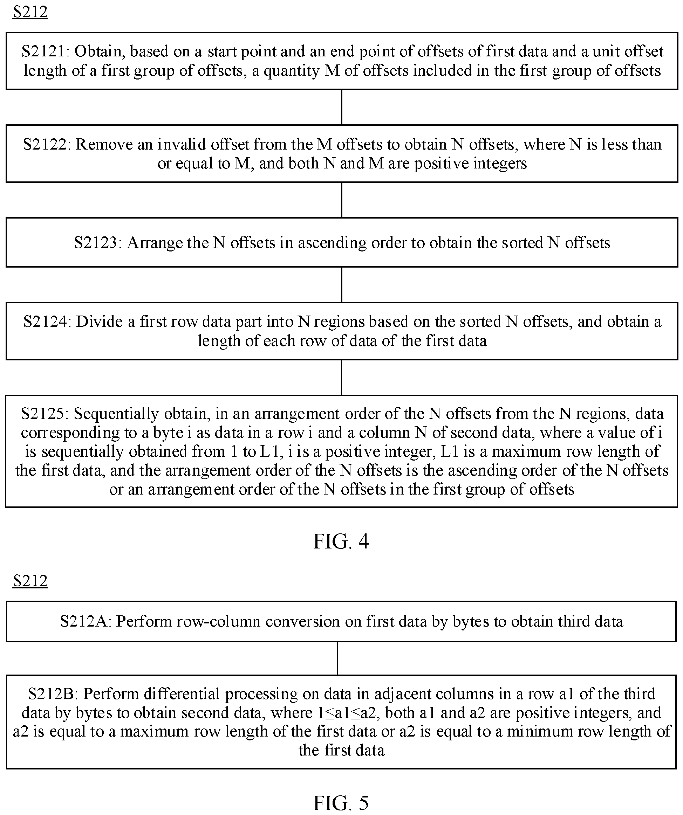

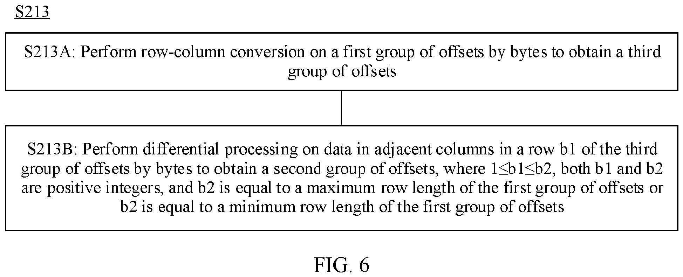

5210 is described in detail below with reference to FIG. 3 to FIG. 13 by using examples when preprocessing is Case 1, Case 2, and Case 3 respectively. FIG. 3 is a schematic flowchart of an example of obtaining the second data page when the preprocessing is Case 1 according to this embodiment of this application. FIG. 4 is a schematic flowchart of an example of obtaining the second data when the preprocessing is Case 1 according to this embodiment of this application. FIG. 5 is a schematic flowchart of an example of obtaining the second data when the preprocessing is Case 2 according to this embodiment of this application. FIG. 6 is a schematic flowchart of an example of obtaining the second group of offsets when the preprocessing is Case 2 according to this embodiment of this application.

Case 1: The preprocessing includes only the byte-level-based row-column conversion.

In Case 1, as shown in FIG. 3, 5210 specifically includes S211 to S214.

S211: Separately obtain the first data and the first group of offsets from the first data page.

Specifically, a start point (rows_begin) and an end point (rows_end) of the first data and a start point (dirs_begin) and an end point (dirs_end) of the offsets corresponding to the first data are first obtained from the first page head. Then, the first data is obtained from the first row data part in the first data page based on the start point (rows_begin) and the end point (rows_end) of the first data, and the first group of offsets is obtained from the first directory part in the first data page based on the start point (dirs_begin) and the end point (dirs_end) of the offsets corresponding to the first data.

A form of the start point and/or a form of the end point are/is not limited in this embodiment of this application. For example, a start point may correspond to a location (for example, a quantity of bytes) of a page head in a data page and/or an end point may correspond to a location (for example, a quantity of bytes) of a page head in a data page.

An order of obtaining the first data and obtaining the first group of offsets is not limited in this embodiment of this application. For example, the first data may be first obtained, and then the first group of offsets is obtained; or the first group of offsets may be first obtained, and then the first data is obtained; or the first data and the first group of offsets may be obtained at the same time.

S212: Perform the preprocessing on the first data by bytes to obtain the second data.

For example, as shown in FIG. 4, S212 includes S2121 to S2125. S2121 to S2125 are described in detail below.

S2121: Obtain, based on the start point (rows_begin) and the end point (rows_end) of the offsets of the first data and a unit offset length of the first group of offsets, a quantity M of offsets (total_dir_cnt) included in the first group of offsets. The start point (rows_begin) and the end point (rows_end) of the offsets of the first data may be obtained from the first page head.

Specifically, M meets the following formula:

$$M = \frac{dirs\_end - dirs\_begin + 1}{sizeof(dir)}$$

Herein, sizeof(dir) is the unit offset length of the first group of offsets.

A value of the unit offset length of the first group of offsets is not limited in this embodiment of this application. Descriptions are provided below by using an example in which the unit offset length of the first group of offsets is two bytes.

For example, if the start point (rows_begin) of the offsets of the first data is a byte a, and the end point (rows_end) of the offsets of the first data is a byte (a+5), M=(a+5-a+1)/2=3, that is, the first group of offsets corresponding to the first data includes three offsets.

It should be noted that the quantity M of offsets included in the first group of offsets may be understood as a quantity of rows of the first data.

S2122: Remove an invalid offset from the M offsets to obtain N offsets, where N is less than or equal to M, and both N and M are positive integers.

In an example, S2122 may be implemented based on information indicating the invalid offset.

If the information indicating the invalid offset indicates that (M-N) offsets are invalid, in this case, the (M-N) offsets need to be removed from the quantity M of offsets obtained in S2121, to obtain the N valid offsets.

A storage location of the information indicating the invalid offset is not limited in this embodiment of this application. For example, information indicating an invalid offset may be stored in a directory part, page head, or page tail.

In another example, S2122 may be implemented based on each offset in the first group of offsets and the start point (rows_begin) and the end point (rows_end) of the first data that are obtained in S211.

Specifically, if the N offsets in the M offsets are between the start point (rows_begin) and the end point (rows_end) of the first data, and the (M-N) offsets are not between the start point (rows_begin) and the end point (rows_end) of the first data, that is, in the M offsets, the N offsets are valid, and the (M-N) offsets are invalid.

In this example, the (M-N) offsets that are not between the start point (rows_begin) and the end point (rows_end) of the first data need to be removed from the quantity M of offsets obtained in S2121, to obtain the N valid offsets.

S2123: Arrange the N offsets in ascending order to obtain the sorted N offsets.

An arrangement order of the N offsets in the directory part is not limited in this embodiment of this application.

In an example, the N offsets are arranged in ascending or descending order in the directory part. In another example, the N offsets may be arranged out of order in the directory part.

It should be noted that, if the N offsets are already arranged in ascending order, the sorted N offsets may be obtained in this case when the step of arranging the N offsets in ascending order is not be performed.

For example, if the three offsets shown in Table 3 are arranged in ascending order, the obtained three sorted offsets are sequentially Ox01, 0x04, and 0x08.

For another example, if the three offsets shown in Table 4 are arranged in ascending order, the obtained three sorted offsets are sequentially Ox01, 0x06, and 0x09.

A manner of arranging the N offsets is not limited in this embodiment of this application. For example, the N offsets may be sorted in an insertion sorting manner.

S2124: Divide the first row data part into N regions based on the sorted N offsets, and obtain a length of each row of data in the first data.

An amount of data in an $n^{th}$ region of the N regions is a length of an $n^{th}$ row of data in the first data, and the data in the $n^{th}$ region of the N regions is data in the $n^{th}$ row of data in the first data.

Specifically, in the first row data part, data corresponding to an $n^{th}$ offset to data before data corresponding to an $(n+1)^{th}$ offset are used as data in the $n^{th}$ region of the N regions, that is, the data in the $n^{th}$ region is the data in the $n^{th}$ row of data in the first data, where a value of n is sequentially obtained from 1 to (N-1), and in the first row data part, data corresponding to an $N^h$ offset and data from the $N^h$ offset to the end point of the offsets of the first data are used as data in an $N^{th}$ region of the N regions. In this way, the first row data part may be divided into the N regions, that is, data in the $N^{th}$ region is an $N^{th}$ row of data in the first data.

Specifically, a difference between the $(n+1)^{th}$ offset and the $n^{th}$ offset is used as a length of the data in the $n^{th}$ region, where a value of n is sequentially obtained from 1 to (N-1); and a sum of 1 and a difference between the end point of the offsets of the first data and the $N^h$ offset is used as a length of the data in the $N^h$ region. This can obtain the length of each row of data in the first data.

For example, the three offsets shown in Table 3 are sequentially Ox01, 0x04, and 0x08 after being sorted. First, in the first row data part, data (a in the row 1 shown in Table 1) corresponding to a first offset (Ox01) to data (c in the row 1 shown in Table 1) before data (a in the row 2 shown in Table 1) corresponding to a second offset (0x04) are used as data in a first region. In this case, the data in the first region of the first data shown in Table 1 is the data (abc) in the row 1 shown in Table 1. A difference between the second offset (0x04) and the first offset (Ox01) is used as a length of the data in the first region, that is, a length of the data in the first region is (Ox04-0x01)=0x03 (bytes).

Then, in the first row data part, data (a in the row 2 shown in Table 1) corresponding to the second offset (0x04) to data (d in the row 2 shown in Table 1) before data (a in the row 3 shown in Table 1) corresponding to a third offset (0x08) are used as data in a second region. In this case, the data in the second region of the first data shown in Table 1 is the data (abed) in the row 2 shown in Table 1. A difference between the third offset (0x08) and the second offset (Ox04) is used as a length of the data in the second region, that is, a length of the data in the second region is (0x08-0x04)=0x04 (bytes).

Finally, data (a in the row 3 shown in Table 1) corresponding to the third offset (0x08) in the first row data part to data from the third offset (0x08) in the first row data part to the end point (for example, 0x0C) of the offsets of the first data C are used as data (b to e in the row 3 shown in Table 1) in a third region. In this case, the data in the third region of the first data shown in Table 1 is the data (abcde) in the row 3 shown in Table 1. A sum of 1 and a difference between the end point of the offsets of the first data and the third offset (0x08) is used as a length of the data in the third region, that is, a length of the data in the third region is (OxOC-Ox08+Ox01)=Ox05 (bytes).

For another example, the three offsets shown in Table 4 are sequentially Ox01, 0x06, and 0x09 after being sorted. First, in the first row data part, data (a in the row 1 shown in Table 1) corresponding to a first offset (Ox01) to data (e in the row 1 shown in Table 1) before data (a in the row 2 shown in Table 1) corresponding to a second offset (0x06) are used as data in a first region. In this case, the data in the first region of the first data shown in Table 1 is the data (abcde) in the row 1 shown in Table 2. A difference between the second offset (0x06) and the first offset (Ox01) is used as a length of the data in the first region, that is, a length of the data in the first region is (Ox06-0x01)=0x05 (bytes).

Then, in the first row data part, data (a in the row 2 shown in Table 1) corresponding to the second offset (0x06) to data (c in the row 2 shown in Table 1) before data (a in the row 3 shown in Table 1) corresponding to a third offset (0x09) are used as data in a second region. In this case, the data in the second region of the first data shown in Table 1 is the data (abc) in the row 2 shown in Table 1. A difference between the third offset (0x09) and the second offset (0x06) is used as a length of the data in the second region, that is, a length of the data in the second region is (0x09-0x06)=0x03 (bytes).

Finally, data (a in the row 3 shown in Table 1) corresponding to the third offset (0x09) in the first row data part to data from the third offset (0x09) in the first row data part to the end point (for example, 0x0C) of the offsets of the first data C are used as data (b to d in the row 3 shown in Table 1) in a third region. In this case, the data in the third region of the first data shown in Table 1 is the data (abcd) in the row 3 shown in Table 1. A sum of 1 and a difference between the end point of the offsets of the first data and the third offset (0x09) is used as a length of the data in the third region, that is, a length of the data in the third region is (0x0C-0x09+0x01)=0x04 (bytes).

An order of dividing the first row data part into the N regions and obtaining the length of each row of data in the first data is not limited in this embodiment of this application. For example, the first row data part may be first divided into the N regions, and then the length of each row of data in the first data is obtained; or the length of each row of data in the first data is first obtained, and then the first row data part is divided into the N regions; or the first row data part may be divided into the N regions, and the length of each row of data in the first data is obtained at the same time.

Optionally, in some embodiments, before S2124 is performed, whether N is less than or equal to a second threshold may be first determined, and then S2124, S2125, S213, and S214 are performed only when N is less than or equal to the second threshold. In this way, the byte-level-based row-column conversion is performed on the first data only when a quantity of rows of the first data is small, and a waste of resources can be avoided.

A specific value of the second threshold is not limited in this embodiment of this application, and may be set based on an actual situation.

S2125: Sequentially obtain, in the arrangement order of the N offsets from the N regions, data corresponding to a byte i as data in a row i and a column N of the second data, where a value of i is sequentially obtained from 1 to L1, i is a positive integer, L1 is a maximum row length of the first data, and the arrangement order of the N offsets is the ascending order of the N offsets or the arrangement order of the N offsets in the first group of offsets.

In an example, if the data stored in the first data page is table data, the arrangement order of the N offsets is the ascending order of the N offsets.

For example, if data in a first region is the data (abc) in the row 1 shown in Table 1, data in a second region is the data (abcd) in the row 2 shown in Table 1, data in a third region is the data (abcde) in the row 3 shown in Table 1, and a maximum row length L1 of the first data is 5, S2125 specifically includes the following steps.

When i=1, sequentially obtain, in the ascending order of the N (in this case, N=3) offsets, namely, a sequence of the first region (a region corresponding to the first offset 0x01), the second region (a region corresponding to the second offset 0x04), and the third region (a region corresponding to the third offset 0x08), data (a) corresponding to a byte 1 from the first region as data in a row 1 and a column 1 of the second data, data (a) corresponding to a byte 1 from the second region as data in the row 1 and a column 2 of the second data, and data (a) corresponding to a byte 1 from the third region as data in the row 1 and a column 3 of the second data. That is, data in a first row of the second data, namely, aaa, may be extracted from the three regions in a first time of data reading.

When i=2, sequentially obtain, in the ascending order of the N (in this case, N=3) offsets, namely, a sequence of the first region (a region corresponding to the first offset 0x01), the second region (a region corresponding to the second offset 0x04), and the third region (a region corresponding to the third offset 0x08), data (b) corresponding to a byte 2 from the first region as data in a row 2 and a column 1 of the second data, data (b) corresponding to a byte 2 from the second region as data in the row 2 and a column 2 of the second data, and data (b) corresponding to a byte 2 from the third region as data in the row 2 and a column 3 of the second data. That is, data in a second row of the second data, namely, bbb, may be extracted from the three regions in a second time of data reading.

When i=3, sequentially obtain, in the ascending order of the N (in this case, N=3) offsets, namely, a sequence of the first region (a region corresponding to the first offset 0x01), the second region (a region corresponding to the second offset 0x04), and the third region (a region corresponding to the third offset 0x08), data (c) corresponding to a byte 3 from the first region as data in a row 3 and a column 1 of the second data, data (c) corresponding to a byte 3 from the second region as data in the row 3 and a column 2 of the second data, and data (c) corresponding to a byte 3 from the third region as data in the row 3 and a column 3 of the second data. That is, data in a third row of the second data, namely, ccc, may be extracted from the three regions in a third time of data reading.

When i=4, sequentially obtain, in the ascending order of the N (in this case, N=3) offsets, namely, a sequence of the first region (a region corresponding to the first offset 0x01), the second region (a region corresponding to the second offset 0x04), and the third region (a region corresponding to the third offset 0x08), data (no data) corresponding to a byte 4 from the first region as data in a row 4 and a column 1 of the second data, data (d) corresponding to a byte 4 from the second region as data in the row 4 and a column 2 of the second data, and data (d) corresponding to a byte 4 from the third region as data in the row 4 and a column 3 of the second data. That is, data in a fourth row of the second data, namely, *dd, may be extracted from the three regions in a fourth time of data reading.

When i=5, sequentially obtain, in the ascending order of the N (in this case, N=3) offsets, namely, a sequence of the first region (a region corresponding to the first offset 0x01), the second region (a region corresponding to the second offset 0x04), and the third region (a region corresponding to the third offset 0x08), data (no data) corresponding to a byte 5 from the first region as data in a row 5 and a column 1 of the second data, data (no data) corresponding to a byte 5 from the second region as data in the row 5 and a column 2 of the second data, and data (e) corresponding to a byte 5 from the third region as data in the row 5 and a column 3 of the second data. That is, data in a fifth row of the second data, namely, **e, may be extracted from the three regions in a fifth time of data reading.

In this example, after the five times of data reading, byte-level-based row-column conversion may be completed on the first data shown in Table 1, to obtain the second data shown in Table 5. For example, as shown in Table 5, the second data includes the five rows of data, where each row of data in the five rows of data occupies three bytes. Data in three bytes in the row 1 is sequentially a, a, and a; data in three bytes in the row 2 is sequentially b, b, and b; data in three bytes in the row 3 is sequentially c, c, and c; data in three bytes in the row 4 is sequentially *, d, and d, and data in three bytes in the row 5 is sequentially *, *, and e.

It should be noted that * in this embodiment of this application indicates that there is no data in the byte.

**Table 5**

| Bytes / Rows | Byte 1 | Byte 2 | Byte 3 |
|---|---|---|---|
| Row 1 | a | a | a |
| Row 2 | b | b | b |
| Row 3 | c | c | c |
| Row 4 | | d | d |
| Row 5 | | | e |

In another example, if the data stored in the first data is index data, the arrangement order of the N offsets is the arrangement order of the N offsets in the first group of offsets.

For example, if data in a first region is the data (abcde) in the row 1 shown in Table 2, data in a second region is the data (abc) in the row 2 shown in Table 1, data in a third region is the data (abed) in the row 3 shown in Table 1, and a maximum row length L1 of the first data is 5, S2125 specifically includes the following steps.

When i=1, sequentially obtain, in the arrangement order of the N (in this case, N=3) offsets in the first group of offsets, namely, a sequence of the second region (a region corresponding to the first offset 0x06), the third region (a region corresponding to the second offset 0x09), and the first region (a region corresponding to the third offset 0x01), data (a) corresponding to a byte 1 from the second region as data in a row 1 and a column 1 of the second data, data (a) corresponding to a byte 1 from the third region as data in the row 1 and a column 2 of the second data, and data (a) corresponding to a byte 1 from the first region as data in the row 1 and a column 3 of the second data. That is, data in a first row of the second data, namely, aaa, may be extracted from the three regions in a first time of data reading.

When i=2, sequentially obtain, in the arrangement order of the N (in this case, N=3) offsets in the first group of offsets, namely, a sequence of the second region (a region corresponding to the first offset 0x06), the third region (a region corresponding to the second offset 0x09), and the first region (a region corresponding to the third offset 0x01), data (b) corresponding to a byte 2 from the second region as data in a row 2 and a column 1 of the second data, data (b) corresponding to a byte 2 from the third region as data in the row 2 and a column 2 of the second data, and data (b) corresponding to a byte 2 from the first region as data in the row 2 and a column 3 of the second data. That is, data in a second row of the second data, namely, bbb, may be extracted from the three regions in a second time of data reading.

When i=3, sequentially obtain, in the arrangement order of the N (in this case, N=3) offsets in the first group of offsets, namely, a sequence of the second region (a region corresponding to the first offset 0x06), the third region (a region corresponding to the second offset 0x09), and the first region (a region corresponding to the third offset 0x01), data (c) corresponding to a byte 3 from the second region as data in a row 3 and a column 1 of the second data, data (c) corresponding to a byte 3 from the third region as data in the row 3 and a column 2 of the second data, and data (c) corresponding to a byte 3 from the first region as data in the row 3 and a column 3 of the second data. That is, data in a third row of the second data, namely, ccc, may be extracted from the three regions in a third time of data reading.

When i=4, sequentially obtain, in the arrangement order of the N (in this case, N=3) offsets in the first group of offsets, namely, a sequence of the second region (a region corresponding to the first offset 0x06), the third region (a region corresponding to the second offset 0x09), and the first region (a region corresponding to the third offset Ox01), data (no data) corresponding to a byte 4 from the second region as data in a row 4 and a column 1 of the second data, data (d) corresponding to a byte 4 from the third region as data in the row 4 and a column 2 of the second data, and data (d) corresponding to a byte 4 from the first region as data in the row 4 and a column 3 of the second data. That is, data in a fourth row of the second data, namely, *dd, may be extracted from the three regions in a fourth time of data reading.

When i=5, sequentially obtain, in the arrangement order of the N (in this case, N=3) offsets in the first group of offsets, namely, a sequence of the second region (a region corresponding to the first offset 0x06), the third region (a region corresponding to the second offset 0x09), and the first region (a region corresponding to the third offset Ox01), data (no data) corresponding to a byte 5 from the second region as data in a row 5 and a column 1 of the second data, data (no data) corresponding to a byte 5 from the third region as data in the row 5 and a column 2 of the second data, and data (e) corresponding to a byte 5 from the first region as data in the row 5 and a column 3 of the second data. That is, data in a fifth row of the second data, namely, **e, may be extracted from the three regions in a fifth time of data reading.

In this example, after the five times of data reading, byte-level-based row-column conversion may be completed on the first data shown in Table 2, to obtain the second data shown in Table 5. For descriptions of Table 5, refer to the foregoing related descriptions. Details are not described herein again.

Optionally, in some embodiments, before S2125 is performed, whether a difference between lengths of the rows of data in the first data is less than or equal to a first threshold may be first determined, that is, S2126 is performed, and S2125, S213, and S214 are performed only when the difference between the lengths of the rows of data in the first data is less than or equal to the first threshold. In this way, the byte-level-based row-column conversion is performed on the first data only when the difference between the lengths of the rows of data in the first data is small, and a waste of resources can be avoided.

A specific value of the first threshold is not limited in this embodiment of this application, and may be set based on an actual situation.

S213: Perform the preprocessing on the first group of offsets by bytes to obtain the second group of offsets.

Specifically, byte-level-based row-column conversion is performed on the N offsets in the first group of offsets by bytes to obtain the second group of offsets.

It should be noted that byte-level-based row-column conversion is performed on the N offsets in the first group of offsets by bytes to obtain the second group of offsets may be understood as follows: Byte-level-based row-column conversion is performed in an arrangement order of the N offsets in the first group of offsets by bytes to obtain the second group of offsets.

For example, Table 6 shows an example of a second group of offsets obtained by performing byte-level-based row-column conversion on the N offsets in the first group of offsets shown in Table 3. For example, as shown in Table 6, the second group of offsets includes two rows of data. A first row of data occupies three bytes, and data in the three bytes is sequentially 0x00, 0x00, and 0x00; and a second row of data occupies three bytes, and data in the three bytes is sequentially Ox01, 0x04, and 0x08.

**Table 6**

| Bytes / Rows | Byte 1 | Byte 2 | Byte 3 |
|---|---|---|---|
| Row 1 | 0x00 | 0x00 | 0x00 |
| Row 2 | 0x01 | 0x04 | 0x08 |

For example, Table 7 shows an example of a second group of offsets obtained by performing byte-level-based row-column conversion on the N offsets in the first group of offsets shown in Table 4. For example, as shown in Table 7, the second group of offsets includes two rows of data. A first row of data occupies three bytes, and data in the three bytes is sequentially 0x00, 0x00, and 0x00; and a second row of data occupies three bytes, and data in the three bytes is sequentially 0x06, 0x09, and 0x01.

**Table 7**

| Bytes / Rows | Byte 1 | Byte 2 | Byte 3 |
|---|---|---|---|
| Row 1 | 0x00 | 0x00 | 0x00 |
| Row 2 | 0x06 | 0x09 | 0x01 |

S214: Obtain the second data page based on the second data and the second group of offsets.

In an example, a data page may be created, and the second data and the second group of offsets are stored in the created data page, to form the second data page.

For example, a data page may be created, where the data page includes a second row data part and a second directory part, the second data is stored in the second row data part, and the second group of offsets is stored in the second directory part. In this way, the created data page is the second data page.

In another example, the second data page may be obtained based on the original first data page.

For example, the first data stored in the first row data part is updated to the second data, and the first group of offsets stored in the first directory part is updated to the second group of offsets, to obtain the second data page.

Case 2: The preprocessing includes the byte-level-based row-column conversion and the byte-level-based differential processing.

In Case 2, 5210 specifically includes S211 to S214. Specific processes of S211 and S214 in Case 2 are the same as specific processes of S211 and S214 in Case 1, and details are not described herein again. Specific processes of S212 and S213 in Case 2 are different from specific processes of S212 and S213 in Case 1. The following describes in detail the specific processes of S212 and S213 in Case 2.

In Case 2, as shown in FIG. 5, S212 specifically includes S212A and S212B. S212A and S212B are described in detail below.

S212A: Perform the row-column conversion on the first data by bytes to obtain third data.

Specifically, S212A includes S2121 to S2124 and S2125A. For descriptions of S2121 to S2124, refer to the foregoing related descriptions. Details are not described herein again. S2125A is focused on herein.

S2125A: Sequentially obtain, in the arrangement order of the N offsets from the N regions, data corresponding to a byte i as data in a row i and a column N of the third data, where a value of i is sequentially obtained from 1 to L1, i is a positive integer, L1 is a maximum row length of the first data, and the arrangement order of the N offsets is the ascending order of the N offsets or the arrangement order of the N offsets in the first group of offsets.

According to the foregoing descriptions of S2125A, it can be learned that a process of S2125A is similar to that of S2125 described above, and a difference between the two processes lies only in that the third data is obtained in S2125A, and the second data is obtained in S2125. Therefore, for detailed descriptions of S2125A, refer to the related descriptions of S2125. Details are not described herein again.

S212B: Perform the differential processing on data in adjacent columns in a row $a1$ of the third data by bytes to obtain the second data, where $1 \leq a1 \leq a2$, both $a1$ and $a2$ are positive integers, and $a2$ is equal to the maximum row length of the first data or $a2$ is equal to a minimum row length of the first data.

For example, if the third data obtained in S212A is shown in Table 5, Table 8 shows an example of second data obtained by performing, by bytes, differential processing on data in adjacent columns in a row $a1$ of the third data shown in Table 5. In Table 8, an example in which $a2$ is equal to a minimum row length (3 bytes) of the first data (as shown in Table 1 or Table 2) is used.

## Table 8

| Bytes / Rows | Byte 1 | Byte 2 | Byte 3 |
|---|---|---|---|
| Row 1 | a | 0 | 0 |
| Row 2 | b | 0 | 0 |
| Row 3 | c | 0 | 0 |
| Row 4 | | d | d |
| Row 5 | | | e |

Optionally, in some embodiments, before S2125A is performed, whether a difference between lengths of the rows of data in the first data is less than or equal to a first threshold may be first determined, that is, S2126A is performed, and S2125A, S213, and S214 are performed only when the difference between the lengths of the rows of data in the first data is less than or equal to the first threshold. In this way, the byte-level-based row-column conversion is performed on the first data only when the difference between the lengths of the rows of data in the first data is small, and a waste of resources can be avoided.

In Case 2, as shown in FIG. 6, S213 specifically includes S213A and S213B. S213A and S213B are described in detail below.

S213A: Perform the row-column conversion on the first group of offsets by bytes to obtain a third group of offsets.

According to the foregoing descriptions of S213A, it can be learned that a process of S213A is similar to that of S213 described above, and a difference between the two processes lies only in that the third group of offsets is obtained in S213A, and the second group of offsets is obtained in S213. Therefore, for detailed descriptions of S213A, refer to the related descriptions of S213. Details are not described herein again.

S213B: Perform the differential processing on data in adjacent columns in a row $b1$ of the third group of offsets by bytes to obtain the second group of offsets, where $1 \leq b1 \leq b2$, both $b1$ and $b2$ are positive integers, and $b2$ is equal to a maximum row length of the first group of offsets or $b2$ is equal to a minimum row length of the first group of offsets.

For example, if the third group of offsets obtained in S213A is shown in Table 6, Table 9 shows an example of second group of offsets obtained by performing, by bytes, differential processing on data in adjacent columns in a row $b1$ of the third group of offsets shown in Table 6. An example in which $b2$ is equal to a minimum row length (two bytes) of the first group of offsets (as shown Table 3) is used.

## Table 9

| Bytes / Rows | Byte 1 | Byte 2 | Byte 3 |
|---|---|---|---|
| Row 1 | 0x00 | 0x00 | 0x00 |
| Row 2 | 0x01 | 0x03 | 0x04 |

For example, if the third group of offsets obtained in S213A is shown in Table 7, Table 10 shows an example of second group of offsets obtained by performing, by bytes, differential processing on data in adjacent columns in a row $b1$ of the third group of offsets shown in Table 7. An example in which $b2$ is equal to a minimum row length (two bytes) of the first group of offsets (as shown Table 4) is used.

**Table 10**

| Bytes / Rows | Byte 1 | Byte 2 | Byte 3 |
|---|---|---|---|
| Row 1 | 0x00 | 0x00 | 0x00 |

| Bytes / Rows | Byte 1 | Byte 2 | Byte 3 |
|---|---|---|---|
| Row 2 | 0x06 | 0x03 | −0x08 |

Optionally, in some embodiments, the second data page includes information indicating that the preprocessing is performed on the second data page. For example, when the preprocessing includes only the byte-level-based row-column conversion, the information may indicate that the byte-level-based row-column conversion processing has been performed on the second data page. For another example, when the preprocessing includes only the byte-level-based row-column conversion and the byte-level-based differential processing, the information may not only indicate that the byte-level-based row-column conversion processing and the byte-level-based differential processing have been performed on the second data page, but also indicate a sequence of the byte-level-based row-column conversion processing and the byte-level-based differential processing.

A storage location, on the second data page, of the information indicating that the preprocessing is performed on the second data page is not limited in this embodiment of this application. For example, the information indicating that the preprocessing is performed on the second data page may be stored in a page head or a page tail in the second data page.

Case 3: The preprocessing includes only the byte-level-based differential processing.

In Case 3, 5210 specifically includes S211 to S214. Specific processes of S211 and S214 in Case 3 are the same as specific processes of S211 and S214 in Case 2, and details are not described herein again. Specific processes of S212 and S213 in Case 3 are different from specific processes of S212 and S213 in Case 2. The following describes in detail the specific processes of S212 and S213 in Case 3.

In Case 3, S212 specifically includes: Perform the differential processing on data in adjacent columns in a row e1 of the first data by bytes to obtain the second data, where $1 \leq e1 \leq a2$, and e1 is a positive integer. For a2, refer to the foregoing related descriptions.

In Case 3, a specific process of S212 is similar to a process of S212B in Case 2. For the specific process of S212 in Case 3, refer to corresponding descriptions of S212B in Case 2. Details are not described herein again.

In Case 3, S213 specifically includes: Perform the differential processing on data in adjacent columns in a row f1 of the first group of offsets by bytes to obtain the second group of offsets, where $1 \leq f1 \leq b2$, and f1 is a positive integer. For b2, refer to the foregoing related descriptions.

In Case 3, a specific process of S213 is similar to a process of S213B in Case 2. For the specific process of S212 in Case 3, refer to corresponding descriptions of S213B in Case 2. Details are not described herein again.

Optionally, in some embodiments, the first data page in S210 may be a first data page obtained by reorganizing a plurality of consecutive third data pages of a same structure. That is, before S210, the method 200 further includes the following step.

S230: Reorganize the plurality of consecutive third data pages of the same structure to obtain the first data page.

The third data page includes fourth data stored in a row-based manner and a fourth group of offsets, the fourth group of offsets indicates an offset of each row of data in the fourth data, the first data includes a plurality of pieces of fourth data corresponding to the plurality of third data pages, maximum row lengths of the plurality of pieces of fourth data are the same, and the first group of offsets includes a plurality of fourth groups of offsets corresponding to the plurality of third data pages.

It should be noted that, that data page structures are the same may be understood as that components of the data pages are consistent.

Specifically, S230 includes the following steps. S231: Separately obtain the plurality of pieces of fourth data and the plurality of fourth groups of offsets that correspond to the plurality of third data pages; S232: Separately arrange the plurality of pieces of fourth data in a target order to obtain the first data, and separately arrange the plurality of fourth groups of offsets in the target order to obtain the first group of offsets, where the target order is an arrangement order of the plurality of third data pages; and S233: Separately store the first data and the first group of offsets into the first data page. In other words, in an arrangement order of the plurality of third data pages, the obtained fourth data stored in row data parts of all of the plurality of third data pages may be sequentially stored together to obtain the first data, and the obtained fourth group of offsets stored in directory parts of all of the plurality of third data pages may be sequentially stored together to obtain the first group of offsets. In this way, the first data page is a data page that aggregates data of the plurality of third data pages, and it may be considered that the first data page is a huge data page in this case.

In this embodiment of this application, a sequence of performing steps of obtaining the first data and obtaining the first group of offsets in S232 is not limited. For example, the first data may be obtained before the first group of offsets, or the first data may be obtained by performing the first group of offsets, or both the first data and the first group of offsets may be obtained at the same time.

Optionally, in some embodiments, if a data page further includes a page head and/or a page tail in addition to a row data part and a directory part, in a process of performing S230, the following steps further need to be performed: First, separately obtain data stored in a plurality of page heads corresponding to the plurality of third data pages and/or data stored in a plurality of page tails corresponding to the plurality of third data pages. Then, separately arrange the data stored in the plurality of page heads and/or the data stored in the plurality of page tails in a target order to obtain data stored in the first page head and/or data stored in the first page tail. Finally, separately store the data stored in the first page head in the page head of the first data page and/or the data stored in the first page tail in the page tail of the first data page. In other words, in the arrangement order of the plurality of third data pages, the data stored in the page heads and/or the page tails of all of the obtained plurality of third data pages are/is sequentially stored together, to obtain the data stored in the first page head and/or the first page tail. In this way, the huge data page, namely, the first data page, is formed.

Optionally, in some embodiments, byte-level-based row-column conversion may be performed on the plurality of third data pages.

For example, whether the byte-level-based row-column conversion can be performed on each third data page may be determined by using the following two conditions: Condition 1: Whether a quantity of valid offsets in the fourth group of offsets stored in each third data page is less than or equal to a fifth threshold; and Condition 2: whether a difference between lengths of rows of data in the fourth data stored in each third data page is less than or equal to a sixth threshold.

A specific value of the fifth threshold is not limited in this embodiment of this application, and may be set based on an actual situation.

A relationship between the fifth threshold and each of the fourth threshold and the second threshold is not limited in this embodiment of this application. For example, the fifth threshold, and the fourth threshold and the second threshold may all be equal.

A specific value of the sixth threshold is not limited in this embodiment of this application, and may be set based on an actual situation.

A relationship between the sixth threshold and each of the third threshold and the first threshold is not limited in this embodiment of this application. For example, the sixth threshold, and the third threshold and the first threshold may all be equal.

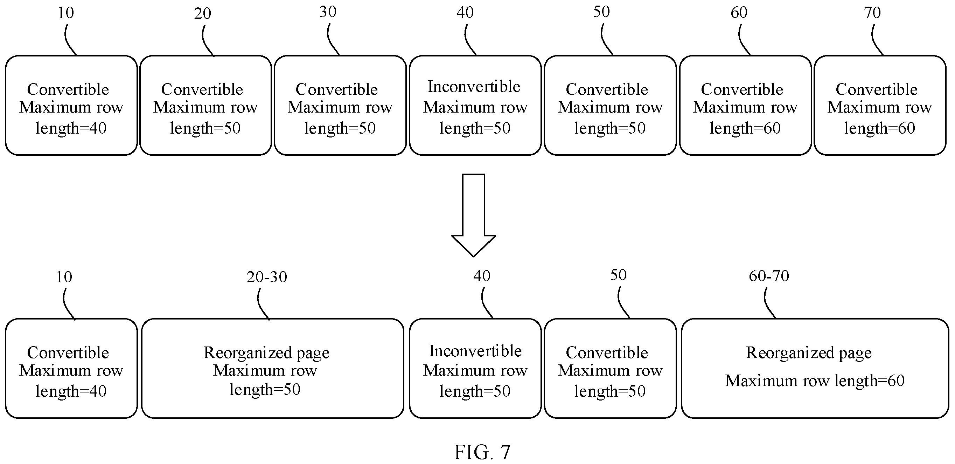

FIG. 7 is a diagram of an example of reorganizing a plurality of data pages according to an embodiment of this application.

For example, as shown in an upper figure in FIG. 7, seven data pages include a data page 10 to a data page 70. Row-column conversion can be performed on the data page 10, and a maximum row length of data stored in a row data part in the data page 10 is 40. Row-column conversion can be performed on both the data page 20 and the data page 30, and both a maximum row length of data stored in a row data part in the data page 20 and a maximum row length of data stored in a row data part in the data page 30 are 50. Row-column conversion cannot be performed on the data page 40, and a maximum row length of data stored in a row data part in the data page 40 is 50. Row-column conversion can be performed on the data page 50, and a maximum row length of data stored in a row data part in the data page 50 is 50. Row-column conversion may be performed on both the data page 60 and the data page 70, and both a maximum row length of data stored in a row data part in the data page 60 and a maximum row length of data stored in a row data part in the data page 70 are 60.

It can be learned from the data page 10 to the data page 70 shown in the upper figure in FIG. 7 that the data page 20 and the data page 30 may be reorganized into one data page, the data page 60 and the data page 70 may be reorganized into one data page, and none of the data page 10, the data page 40, and the data page 50 can be reorganized.

Further, five data pages shown in a lower figure in FIG. 7 may be obtained by reorganizing the data page 10 to the data page 70 shown in the upper figure in FIG. 7. The five data pages include the data page 10, a data page 20-30, the data page 40, the data page 50, and a data page 60-70. The data page 20-30 is the data page obtained by reorganizing the data page 20 and the data page 30, and the data page 60-70 is the data page obtained by reorganizing the data page 60 and the data page 70.

Optionally, in some embodiments, the first data page includes information indicating that the reorganization is performed on the first data page.

A storage location, on the first data page, of the information indicating that the reorganization is performed on the first data page is not limited in this embodiment of this application. For example, the information indicating that the reorganization is performed on the first data page may be stored in the page head or the page tail in the first data page.

S220: Compress the second data page to obtain a compressed data page.

A compression algorithm for compressing the second data page is not limited in this embodiment of this application.

For example, the second data page may be compressed by using a general compression algorithm (for example, zlib, lz4, or zstd), to obtain a compressed data page.

It should be noted that, before compressing a data page by using the data page compression method 200 described above, a user may first set a compression parameter, and then compress, with the compression parameter set by the user, the data page by using the data page compression method 200 described above, to complete data page compression.

Content specifically included in the compression parameter is not limited in this embodiment of this application. For example, the compression parameter may include at least one of the following: a quantity of data pages compressed once, a preprocessing manner, and a type of the compression algorithm in S220. A minimum value of the page quantity of data pages compressed once is 1. The preprocessing manner includes row-column conversion and/or differential processing. The type of the compression algorithm in S220 may include zlib, lz4, zstd, and the like.

A specific representation form of the compression parameter is not limited in this embodiment of this application. For example, the compression parameter may be designed at a tablespace level, file level, or table level, or may be user-designed.

In one aspect, generally, data stored in columns is similar, repetitive, and regular. Therefore, a compression ratio of the data stored in a column-based manner is higher than that of data stored in a row-based manner. In an embodiment in which the preprocessing in the method 200 includes the byte-level-based row-column conversion, the data stored in the row-based manner is converted into data stored in a column-based manner in an ordered reversible manner, so that the data page is compressed after the data is updated in place in the data page. This can fully use data structure characteristics, and improve a compression ratio of the data page. In addition, compression time consumed in the data compression method 200 provided in this embodiment of this application is basically the same as that in the conventional compression method.

In another aspect, generally, there is a high probability that data in a same column is highly repetitive and regular. Therefore, in an embodiment in which the preprocessing in the method 200 includes the byte-level-based differential processing, more repetitive data can be produced after the byte-level-based differential processing is performed between column data. This can fully use data structure characteristics, further improve a data repetition degree and regularity, and improve a compression ratio of the data page. In addition, compression time consumed in the data compression method 200 provided in this embodiment of this application is basically the same as that in the conventional compression method.

In still another aspect, generally, a data page is regular. Therefore, before the byte-level-based row-column conversion is performed on the data page, a plurality of consecutive data pages of a same structure may be reorganized to obtain one data page. This can fully use data page structure characteristics, reorganize the plurality of data pages that are highly similar into one data page, and improve a compression ratio of the data page. In addition, compression time consumed in the data compression method 200 provided in this embodiment of this application is basically the same as that in the conventional compression method.

Compression performance (for example, a compression ratio or compression time consumed) of the data compression method 200 provided in embodiments of this application is described in detail with reference to Table 11 to Table 16.

Based on the data compression method 200 provided in embodiments of this application and the conventional compression method, in embodiments of this application, a TPCC test is performed on a plurality of pieces of data stored in a row-based manner. For details, refer to Table 11 to Table 16.

Processing manners in Table 11 and Table 12 include ① a processing manner of performing compression by using a conventional general compression algorithm, ② a processing manner of performing byte-level-based row-column conversion in a data page+compression by using a conventional general compression algorithm, ③ a processing manner of performing byte-level-based row-column conversion in a data page+differential processing+compression by using a conventional general compression algorithm, ④ a processing manner of performing data page reorganization+byte-level-based row-column conversion in a data page+compression by using a conventional general compression algorithm, and (5) a processing manner of performing data page reorganization+byte-level-based row-column conversion in a data page+differential processing+compression by using a conventional general compression algorithm.

In Table 11 and Table 12, each piece of index data in a database GaussDB V3 is used as an example. A compression level corresponding to Table 11 is 9, and a compression level corresponding to Table 12 is 1.

In Table 13, each piece of index data in a database PG is used as an example, and Table 13 shows an example of compressing a data page.

In Table 14 and Table 15, each table data in a database GaussDB V3 is used as an example. A compression level corresponding to Table 14 is 9, and a compression level corresponding to Table 15 is 1.

In Table 16, each table data in a database PG is used as an example, and Table 16 shows an example of compressing a data page.

In Table 11 to Table 15, that a zstd general algorithm is used in S220 in the method 200 is used as an example. In Table 16, in addition to an example in which a zstd general algorithm is used in S220 in the method 200, an example in which an lz4 general algorithm is used in S220 in the method 200 is further used.

**Table 11**

| Compression level 9 | | | | | | | | | | | | |
|---|---|---|---|---|---|---|---|---|---|---|---|---|
| File name of an object | Proce ssing mann er | Size before compr ession | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| idx_b | ① | 1G | **126** | **101** | **84** | **75** | **70** | **34.20** | **23.81** | **14.54** | **12.01** | **10.93** |
| File name of an object msql_ oorde r_pke y | Proce ssing mann er | Size before compr ession | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ② | | **62** | **38** | **24** | **17** | **14** | **31.5** | **19.01** | **13.68** | **10.84** | **9.17** |
| | ③ | | **20** | **13** | **Table 9** | **7** | **6** | **33.60** | **21.26** | **15.71** | **12.50** | **11.20** |
| | ④ | | **62** | **35** | **19** | **10** | **6** | **31.50** | **18.51** | **13.42** | **10.38** | **8.56** |
| | ⑤ | | **20** | **34** | **19** | **10** | **6** | **33.71** | **21.25** | **15.24** | **12.60** | **11.14** |
| idx_b msql_ oorde r_idx 1 | ① | 1G | 121 | 99 | 88 | 83 | 80 | 35.65 | 27.10 | 15.61 | 12.91 | 1.70 |
| | ② | | 71 | 60 | 56 | 52 | 50 | 32.10 | 20.80 | 14.83 | 12.25 | 10.69 |
| | ③ | | 39 | 32 | 28 | 26 | 25 | 38.11 | 23.80 | 15.99 | 13.55 | 12.46 |
| | ④ | | 71 | 58 | 50 | 46 | 44 | 32.58 | 20.49 | 14.27 | 11.49 | 9.91 |
| | ⑤ | | 39 | 54 | 49 | 46 | 44 | 41.17 | 22.78 | 16.09 | 13.46 | 11.83 |
| idx_b msql_ new_ order _pkey | ① | 360 M | 43 | 33 | 29 | 28 | 29 | 11.93 | 8.77 | 5.42 | 4.34 | 4.28 |
| | ② | | 21 | 13 | 8 | 6 | 4 | 11.24 | 8.59 | 4.82 | 3.88 | 3.39 |
| | ③ | | 7 | 4 | 3 | 2 | 2 | 11.76 | 7.45 | 5.28 | 4.42 | 4.02 |
| | ④ | | 21 | 12 | 6 | 3 | 2 | 11.00 | 6.49 | 4.73 | 3.68 | 3.03 |
| | ⑤ | | 7 | 12 | 6 | 3 | 2 | 11.85 | 7.45 | 5.36 | 4.46 | 3.94 |
| idx_b msql_ order _line_ pkey | ① | 1G | **139** | **112** | **99** | **92** | **89** | **33.64** | **23.91** | **16.22** | **13.81** | **14.32** |
| | ② | | **52** | **34** | **25** | **20** | **18** | **31.89** | **20.11** | **13.88** | **11.12** | **10.00** |
| | ③ | | **29** | **21** | **16** | **14** | **13** | **35.17** | **25.33** | **17.22** | **13.59** | **12.43** |
| | ④ | | **52** | **32** | **21** | **15** | **12** | **31.59** | **19.44** | **13.79** | **11.05** | **9.55** |
| | ⑤ | | **29** | **31** | **21** | **15** | **12** | **35.4** | **21.93** | **15.58** | **13.19** | **11.81** |
| idx_b msql_ stock _pkey | ① | 1G | 168 | 130 | 110 | 100 | 95 | 34.02 | 23.28 | 15.08 | 12.43 | 12.10 |
| | ② | | 68 | 41 | 27 | 19 | 16 | 32.55 | 19.41 | 13.94 | 11.25 | 10.12 |
| | ③ | | 24 | 18 | 14 | 12 | 10 | 34.03 | 23.56 | 15.60 | 13.22 | 12.01 |
| | ④ | | 68 | 38 | 22 | 14 | 10 | 31.06 | 18.99 | 13.66 | 10.83 | 9.15 |
| | ⑤ | | 24 | 38 | 22 | 14 | 10 | 34.11 | 21.51 | 15.41 | 12.96 | 11.72 |

(continued)

| Compression level 9 | | | | | | | | | | | | |
|---|---|---|---|---|---|---|---|---|---|---|---|---|
| File name of an object | Proce ssing mann er | Size before compr ession | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| idx_b msql_ custo | ① | 1G | 75 | 58 | 50 | 45 | 43 | 28.49 | 16.80 | 10.46 | 7.78 | 6.99 |
| | ② | | 32 | 21 | 14 | 10 | 8 | 27.68 | 16.02 | 10.60 | 7.99 | 6.58 |
| | ③ | | 13 | 9 | 7 | 6 | 5 | 28.75 | 17.67 | 11.33 | 8.84 | 7.42 |
| File name of an objecter mer_p key | Proce ssing mann er | Size before compr ession | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ④ | | 32 | 20 | 12 | 7 | 5 | 28.57 | 15.78 | 10.45 | 7.74 | 5.96 |
| | ⑤ | | 13 | 20 | 12 | 7 | 5 | 28.97 | 17.10 | 11.37 | 8.86 | 7.30 |
| idx_b msql_ custo mer_i dx1 | ① | 1G | 224 | 214 | 209 | 205 | 201 | 38.50 | 27.29 | 16.04 | 15.99 | 15.28 |
| | ② | | 200 | 191 | 186 | 182 | 180 | 35.32 | 23.20 | 16.70 | 14.73 | 14.12 |
| | ③ | | 211 | 204 | 199 | 196 | 194 | 39.53 | 26.87 | 18.29 | 16.56 | 16.06 |
| | ④ | | 200 | 188 | 180 | 176 | 174 | 35.74 | 22.91 | 5.72 | 13.48 | 13.37 |
| | ⑤ | | 211 | 191 | 185 | 180 | 177 | 39.56 | 25.00 | 17.20 | 15.52 | 14.46 |
| idx_b msql_ histor y_idx 1 | ① | 1G | 144 | 127 | 117 | 112 | 110 | 35.06 | 26.84 | 13.10 | 10.77 | 10.25 |
| | ② | | 83 | 60 | 46 | 37 | 32 | 32.37 | 20.06 | 13.75 | 11.17 | 9.93 |
| | ③ | | 31 | 23 | 19 | 17 | 15 | 33.18 | 23.14 | 15.67 | 13.47 | 12.37 |
| | ④ | | 83 | 57 | 39 | 28 | 22 | 32.38 | 19.95 | 13.37 | 10.59 | 9.34 |
| | ⑤ | | 31 | 55 | 38 | 28 | 21 | 33.57 | 22.03 | 15.00 | 12.57 | 11.23 |

**Table 12**

| Compr ression level 1 | | | | | | | | | | | | |
|---|---|---|---|---|---|---|---|---|---|---|---|---|
| File name of an obj ect | Proce ssing mann er | Size before compr ession | Size after co mpress ion (uni t: M) | | | | | Compres ssion tim e consu med (u nit: S) | | | | |
| | | | 1 data page | 2 data pages | 4 data pages | 8 data pages | 16 data pages | 1 data page | 2 data pages | 4 data pages | 8 data pages | 16 data pages |
| idx_b msql_ oorde r_pke y | ① | 1G | 128 | 108 | 94 | 88 | 87 | 25.73 | 14.03 | 7.64 | 3.05 | 3.31 |
| | ② | | 65 | 41 | 29 | 21 | 17 | 29.88 | 17.20 | 11.11 | 8.06 | 6.87 |
| | ③ | | 24 | 15 | 10 | 7 | 6 | 29.41 | 18.86 | 13.08 | 10.09 | 8.76 |
| | ④ | | 62 | 38 | 22 | 14 | 10 | 29.88 | 17.30 | 11.13 | 8.10 | 6.88 |
| | ⑤ | | 24 | 37 | 22 | 14 | 10 | 29.34 | 18.68 | 13.33 | 10.32 | 8.84 |
| idx_b msql_ oorde | ① | 1G | 124 | 128 | 127 | 128 | 127 | 34.95 | 14.40 | 5.75 | 4.51 | 3.37 |
| | ② | | 74 | 64 | 62 | 59 | 56 | 29.89 | 17.00 | 11.42 | 8.13 | 6.79 |
| | ③ | | 44 | 37 | 32 | 29 | 28 | 30.13 | 18.52 | 13.35 | 10.50 | 8.96 |

| Compression level 1 | | | | | | | | | | | | |
|---|---|---|---|---|---|---|---|---|---|---|---|---|
| File name of an object r_idx 1 | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ④ | | 74 | 61 | 55 | 52 | 50 | 29.60 | 17.00 | 11.44 | 8.30 | 6.86 |
| | ⑤ | | 44 | 57 | 24 | 51 | 50 | 30.50 | 19.16 | 14.66 | 10.55 | 8.70 |
| idx_bmsql_new_order_pkey | ① | 360 M | 44 | 46 | 41 | 40 | 40 | 9.19 | 5.11 | 2.49 | 1.43 | 1.11 |
| | ② | | 22 | 14 | 10 | 7 | 5 | 10.53 | 6.12 | 3.98 | 2.94 | 2.46 |
| | ③ | | 8 | 5 | 3 | 2 | 2 | 11.82 | 6.43 | 4.68 | 3.68 | 3.11 |
| | ④ | | 22 | 13 | 8 | 5 | 3 | 10.57 | 6.14 | 3.99 | 3.08 | 2.49 |
| | ⑤ | | 8 | 13 | 8 | 5 | 3 | 10.34 | 6.64 | 4.77 | 3.70 | 3.16 |
| idx_bmsql_stock_pkey | ① | 1G | 144 | 119 | 102 | 97 | 94 | 24.82 | 13.90 | 7.48 | 3.07 | 3.19 |
| | ② | | 56 | 40 | 33 | 27 | 24 | 29.48 | 17.04 | 11.20 | 8.21 | 6.90 |
| | ③ | | 34 | 25 | 20 | 18 | 16 | 30.47 | 18.50 | 13.17 | 10.28 | 8.79 |
| | ④ | | 56 | 38 | 28 | 23 | 21 | 29.76 | 17.17 | 11.45 | 8.22 | 6.96 |
| | ⑤ | | 34 | 38 | 27 | 23 | 20 | 30.41 | 18.80 | 13.40 | 10.47 | 8.97 |
| idx_bmsql_orderline pkey | ① | 1G | 173 | 135 | 114 | 104 | 99 | 26.36 | 14.28 | 7.88 | 3.51 | 2.97 |
| | ② | | 71 | 44 | 30 | 23 | 20 | 29.60 | 17.13 | 11.25 | 8.20 | 6.81 |
| | ③ | | 31 | 22 | 17 | 14 | 13 | 30.00 | 18.30 | 13.21 | 10.37 | 8.82 |
| | ④ | | 71 | 40 | 24 | 15 | 11 | 29.66 | 17.90 | 11.29 | 8.17 | 6.86 |
| | ⑤ | | 31 | 40 | 24 | 15 | 11 | 30.14 | 18.92 | 13.48 | 10.52 | 8.96 |
| idx_bmsql_customer_pkey | ① | 1G | 78 | 61 | 52 | 47 | 45 | 24.43 | 13.23 | 6.89 | 3.28 | 2.68 |
| | ② | | 34 | 24 | 16 | 13 | 11 | 26 | 14.57 | 8.76 | 5.85 | 4.52 |
| | ③ | | 16 | 11 | 9 | 7 | 6 | 46 | 15.23 | 9.82 | 6.94 | 5.49 |
| | ④ | | 34 | 22 | 14 | 10 | 8 | 26.82 | 14.59 | 8.85 | 5.90 | 4.57 |
| | ⑤ | | 16 | 22 | 14 | 10 | 8 | 26.49 | 15.42 | 9.90 | 7.07 | 5.64 |
| idx_bmsql_customer_idx1 | ① | 1G | 234 | 227 | 223 | 219 | 218 | 26.89 | 9.55 | 8.48 | 5.73 | 3.71 |
| | ② | | 211 | 201 | 197 | 194 | 192 | 25.88 | 13.14 | 11.46 | 8.67 | 7.13 |
| | ③ | | 216 | 209 | 206 | 203 | 202 | 28.44 | 15.15 | 12.74 | 10.11 | 8.96 |
| | ④ | | 211 | 197 | 192 | 187 | 185 | 30.37 | 13.27 | 11.36 | 8.62 | 7.50 |
| | ⑤ | | 216 | 199 | 196 | 191 | 188 | 30.98 | 14.97 | 12.51 | 10.02 | 8.91 |
| idx_b | ① | 1G | 145 | 133 | 123 | 118 | 118 | 30.39 | 13.99 | 5.05 | 4.48 | 3.22 |
| File name of an object msql_history_idx 1 | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ② | | 92 | 69 | 55 | 45 | 40 | 25.02 | 16.61 | 11.05 | 7.90 | 3.29 |
| | ③ | | 34 | 26 | 22 | 20 | 18 | 28.73 | 17.90 | 12.75 | 9.72 | 8.27 |
| | ④ | | 92 | 62 | 45 | 33 | 26 | 29.69 | 16.65 | 11.03 | 8.04 | 6.59 |
| | ⑤ | | 34 | 61 | 44 | 33 | 26 | 28.86 | 18.41 | 12.94 | 1.02 | 8.44 |

**Table 13**

| File name of an object | Processing manner | Size before compression | zstd | | | | lz4 | |
|---|---|---|---|---|---|---|---|---|
| | | | Compression level 9 | | Compression level 1 | | Size after compression (unit: M) | Compression time consumed (unit: S) |
| | | | Size after compression (unit: M) | Compression time consumed (unit: S) | Size after compression (unit: M) | Compression time consumed (unit: S) | | |
| idx_bm sql_oor der_pk ey | ① | 1G | 118 | 33.25 | 119 | 18.54 | 255 | 15 |
| | ② | | 48 | 28.37 | 50 | 20.54 | 58 | 17.49 |
| | ③ | | 17 | 27.74 | 19 | 21.43 | 27 | 17.6 |
| idx_bm sql_oor der_idx 1 | ① | 1G | 130 | 32.85 | 147 | 17.43 | 258 | 13.65 |
| | ② | | 66 | 23.67 | 69 | 23.48 | 83 | 18.14 |
| | ③ | | 41 | 28.1 | 45 | 23.56 | 62 | 18.42 |
| idx_bm sql_ne w_orde r_pkey | ① | 270 M | 45 | 12.76 | 46 | 5.61 | 105 | 3.95 |
| | ② | | 15 | 6.76 | 15 | 6.2 | 18 | 4.8 |
| | ③ | | 4 | 7.21 | 5 | 6.46 | 7 | 5.32 |
| idx_bm sql_ord er_line _pkey | ① | 1G | 126 | 25.59 | 128 | 20.76 | 238 | 13.97 |
| | ② | | 41 | 22.53 | 44 | 21.25 | 57 | 16.21 |
| | ③ | | 25 | 25.32 | 27 | 22.74 | 43 | 18.26 |
| idx_bm sql_sto ck_pke Y | ① | 1G | 195 | 33.51 | 199 | 16.71 | 385 | 10.34 |
| | ② | | 62 | 24.73 | 65 | 20.82 | 81 | 17.93 |
| | ③ | | 29 | 28.43 | 34 | 22.8 | 50 | 19.61 |
| idx_bm sql_cus tomer_ pkey | ① | 1G | 147 | 34.07 | 150 | 20.25 | 277 | 13.59 |
| | ② | | 62 | 25.37 | 66 | 25.33 | 82 | 18.94 |
| | ③ | | 30 | 29.11 | 36 | 24.8 | 53 | 19.68 |
| idx_bm sql_cus tomer_i dx1 | ① | 1G | 334 | 38.57 | 356 | 22.18 | 449 | 11.2 |
| | ② | | 311 | 33.37 | 320 | 25.02 | 390 | 17.92 |
| | ③ | | 318 | 37.88 | 324 | 27.07 | 391 | 19.44 |
| idx_bm sql_hist ory_idx 1 | ① | 1G | 150 | 27.24 | 149 | 20.32 | 249 | 14.9 |
| | ② | | 75 | 24.61 | 82 | 24.71 | 95 | 17.16 |
| | ③ | | 48 | 25 | 55 | 24.08 | 68 | 18.85 |

**Table 14**

| Compression level 9 | | | | | | | | | | | | | |
|---|---|---|---|---|---|---|---|---|---|---|---|---|---|
| File name of an object | Proce ssing mann er | Size before compr ession | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| tbl_b msql_ oorde r | ① | 1G | **153** | **136** | **126** | **120** | **118** | **41.04** | **30.26** | **14.02** | **12.80** | **12.71** |
| | ② | | **94** | **77** | **66** | **59** | **56** | **31.31** | **20.11** | **13.62** | **10.95** | **9.85** |
| | ③ | | **69** | **60** | **56** | **53** | **52** | **33.34** | **22.82** | **15.18** | **12.36** | **11.64** |
| | ④ | | **94** | **77** | **64** | **57** | **53** | **31.19** | **19.96** | **13.40** | **10.45** | **9.78** |

(continued)

| Compression level 9 | | | | | | | | | | | | |
|---|---|---|---|---|---|---|---|---|---|---|---|---|
| File name of an object | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ⑤ | | **69** | **72** | **63** | **57** | **54** | **33.28** | **22.16** | **15.16** | **13.36** | **11.64** |
| tbl_bmsql_history | ① | 1G | 292 | 282 | 278 | 177 | 277 | 41.70 | 31.36 | 16.79 | 15.35 | 14.64 |
| | ② | | 252 | 231 | 217 | 208 | 202 | 33.16 | 20.18 | 15.52 | 13.50 | 13.00 |
| | ③ | | 232 | 223 | 217 | 213 | 211 | 36.69 | 24.04 | 17.99 | 16.30 | 14.65 |
| | ④ | | 252 | 228 | 210 | 199 | 191 | 33.06 | 19.01 | 14.75 | 12.66 | 11.66 |
| | ⑤ | | 232 | 228 | 210 | 199 | 191 | 36.63 | 20.76 | 16.69 | 14.27 | 13.72 |
| tbl_bmsql_new_order | ① | 250 M | 30 | 21 | 16 | 13 | 13 | 7.96 | 5.25 | 3.34 | 2.62 | 2.22 |
| | ② | | 14 | 8 | 5 | 3 | 2 | 7.70 | 4.72 | 3.39 | 2.66 | 2.32 |
| | ③ | | 5 | 3 | 2 | 2 | 1 | 8.07 | 5.18 | 3.80 | 3.15 | 2.88 |
| | ④ | | 14 | 8 | 5 | 3 | 2 | 7.72 | 4.65 | 3.39 | 2.66 | 2.34 |
| | ⑤ | | 5 | 8 | 5 | 3 | 2 | 8.09 | 5.22 | 3.86 | 3.19 | 2.93 |
| tbl_bmsql_order_line | ① | 1G | 375 | 351 | 337 | 329 | 326 | 44.14 | 32.65 | 18.47 | 17.67 | 17.91 |
| | ② | | 331 | 307 | 295 | 288 | 284 | 35.45 | 21.60 | 17.08 | 15.25 | 14.75 |
| | ③ | | 336 | 322 | 315 | 310 | 308 | 41.12 | 36.70 | 19.79 | 17.19 | 16.51 |
| | ④ | | 331 | 306 | 291 | 283 | 279 | 35.38 | 20.39 | 16.40 | 14.29 | 13.24 |
| | ⑤ | | 336 | 307 | 295 | 288 | 285 | 41.19 | 23.74 | 18.98 | 16.54 | 15.67 |
| tbl_bmsql_stock (a majority of random numbers) | ① | 1G | **606** | **597** | **592** | **591** | **592** | **41.74** | **43.32** | **23.05** | **23.00** | **26.72** |
| | ② | | **582** | **571** | **566** | **565** | **565** | **39.33** | **40.12** | **22.19** | **20.80** | **21.18** |
| | ③ | | **680** | **669** | **663** | **660** | **658** | **41.05** | **10.40** | **23.99** | **23.32** | **23.17** |
| | ④ | | **582** | **569** | **563** | **560** | **559** | **38.99** | **33.34** | **19.81** | **16.66** | **17.43** |
| | ⑤ | | **680** | **575** | **574** | **572** | **571** | **40.89** | **35.51** | **22.13** | **20.12** | **19.93** |
| tbl_bmsql_custo | ① | 1G | 634 | 620 | 614 | 611 | 610 | 33.93 | 35.69 | 20.29 | 17.24 | 21.26 |
| | ø | | 634 | 620 | 614 | 611 | 610 | 33.60 | 35.89 | 18.83 | 16.93 | 20.13 |
| | (3) | | 634 | 620 | 614 | 611 | 610 | 33.50 | 35.72 | 18.84 | 16.99 | 20.20 |
| File name of an object mer (a vast majority of random numbers) | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ④ | | 634 | 620 | 614 | 611 | 610 | 33.82 | 35.77 | 18.80 | 16.99 | 19.88 |
| | ⑤ | | 634 | 620 | 614 | 611 | 610 | 33.94 | 35.86 | 18.77 | 17.01 | 20.01 |

**Table 15**

| Compression level 1 | | | | | | | | | | | | |
|---|---|---|---|---|---|---|---|---|---|---|---|---|
| File name of an object | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| tbl_bmsql_oorde r | ① | 1G | 161 | 146 | 137 | 134 | 134 | 25.83 | 14.17 | 5.58 | 5.03 | 3.30 |
| | ② | | 97 | 80 | 68 | 60 | 56 | 28.42 | 16.59 | 10.93 | 7.51 | 6.65 |
| | ③ | | 71 | 62 | 57 | 53 | 52 | 30.39 | 18.62 | 12.71 | 9.60 | 8.87 |
| | ④ | | 9 | 79 | 66 | 58 | 54 | 28.28 | 18.57 | 10.99 | 7.49 | 6.70 |
| | ⑤ | | 71 | 75 | 65 | 58 | 54 | 33.68 | 18.76 | 12.58 | 9.55 | 8.82 |
| tbl_bmsql_histor y | ① | 1G | 298 | 290 | 286 | 284 | 284 | 26.10 | 9.72 | 7.30 | 6.03 | 4.62 |
| | ② | | 258 | 237 | 225 | 216 | 211 | 28.98 | 13.71 | 12.12 | 9.46 | 8.04 |
| | ③ | | 237 | 228 | 223 | 220 | 218 | 31.60 | 15.61 | 13.57 | 11.11 | 9.78 |
| | ④ | | 258 | 233 | 218 | 208 | 201 | 29.06 | 13.80 | 12.13 | 9.56 | 8.45 |
| | ⑤ | | 237 | 233 | 218 | 208 | 201 | 31.51 | 16.49 | 13.57 | 11.26 | 10.16 |
| tbl_bmsql_new_ | ① | 250 M | 30 | 27 | 24 | 20 | 19 | 6.06 | 3.41 | 1.73 | 0.96 | 0.82 |
| | ② | | 15 | 9 | 6 | 4 | 2 | 7.00 | 4.18 | 2.83 | 2.08 | 1.77 |
| | ③ | | 6 | 4 | 2 | 2 | 1 | 8.44 | 4.67 | 3.29 | 2.62 | 2.33 |
| File name of an object order | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| | ④ | | 15 | 9 | 6 | 4 | 2 | 8.08 | 4.22 | 2.87 | 2.11 | 1.80 |
| | ⑤ | | 6 | 9 | 6 | 4 | 2 | 7.56 | 4.75 | 3.38 | 2.68 | 2.38 |
| tbl_bmsql_order _line | ① | 1G | 378 | 356 | 342 | 335 | 331 | 26.78 | 8.63 | 9.07 | 6.52 | 4.55 |
| | ② | | 337 | 314 | 301 | 294 | 290 | 29.94 | 13.55 | 13.61 | 10.56 | 9.33 |
| | ③ | | 342 | 328 | 320 | 315 | 313 | 33.98 | 17.10 | 15.75 | 13.09 | 12.00 |
| | ④ | | 337 | 311 | 296 | 288 | 283 | 30.07 | 13.74 | 13.39 | 10.51 | 9.29 |
| | ⑤ | | 342 | 313 | 299 | 293 | 289 | 33.81 | 16.48 | 15.66 | 12.98 | 12.11 |
| tbl_bmsql_stock (a ma-jor ity of ran-do m numb ers) | ① | 1G | 611 | 601 | 599 | 598 | 599 | 15.25 | 17.64 | 11.78 | 7.41 | 6.75 |
| | ② | | 590 | 576 | 568 | 566 | 566 | 19.78 | 21.47 | 16.01 | 13.17 | 11.49 |
| | ③ | | 683 | 671 | 664 | 660 | 659 | 23.14 | 25.34 | 17.48 | 16.00 | 14.44 |
| | ④ | | 590 | 576 | 567 | 564 | 562 | 19.69 | 20.67 | 15.23 | 12.52 | 11.14 |
| | ⑤ | | 683 | 581 | 577 | 575 | 573 | 22.84 | 23.30 | 17.23 | 16.45 | 13.96 |

| Compression level 1 | | | | | | | | | | | | |
|---|---|---|---|---|---|---|---|---|---|---|---|---|
| File name of an object | Processing manner | Size before compression | Size after compression (unit: M) | | | | | Compression time consumed (unit: S) | | | | |
| | | | 1 data page | 2 data pages | 4 data pages | 8 data pages | 16 data pages | 1 data page | 2 data pages | 4 data pages | 8 data pages | 16 data pages |
| tbl_bmsql_customer (a vast majority of random numbers) | ① | 1G | 637 | 324 | 619 | 617 | 617 | 13.27 | 15.89 | 10.70 | 6.64 | 5.44 |
| | ② | | 637 | 324 | 619 | 617 | 617 | 13.30 | 15.97 | 10.74 | 6.80 | 5.61 |
| | ③ | | 637 | 324 | 619 | 617 | 617 | 13.23 | 16.52 | 10.85 | 6.78 | 5.50 |
| | ④ | | 637 | 324 | 619 | 617 | 617 | 13.23 | 15.97 | 10.72 | 6.71 | 5.49 |
| | ⑤ | | 637 | 324 | 619 | 617 | 617 | 13.21 | 16.06 | 10.81 | 6.72 | 5.49 |

**Table 16**

| File name of an object | Processing manner | Size before compression | zstd | | | | lz4 | |
|---|---|---|---|---|---|---|---|---|
| | | | Compression level 9 | | Compression level 1 | | Size after compression (unit: M) | Compression time consumed (unit: S) |
| | | | Size after compression (unit: M) | Compression time consumed (unit: S) | Size after compression (unit: M) | Compression time consumed (unit: S) | | |
| tbl_bmsql_oorder | ① | 1G | 199 | 37.75 | 208 | 21.8 | 337 | 14.72 |
| | ② | | 112 | 27.08 | 118 | 25.47 | 135 | 19.04 |
| | ③ | | 71 | 30.24 | 72 | 27.4 | 98 | 22.14 |
| tbl_bmsql_history | ① | 1G | 366 | 44.96 | 376 | 24.26 | 508 | 9.16 |
| | ② | | 310 | 29.62 | 315 | 28.11 | 362 | 19.46 |
| | ③ | | 279 | 34.76 | 284 | 27.87 | 319 | 23.08 |
| tbl_bmsql_new_order | ① | 380 M | 50 | 21.4 | 49 | 7.39 | 114 | 5.74 |
| | ② | | 19 | 9.72 | 21 | 8.67 | 25 | 6.78 |
| | ③ | | 6 | 9.55 | 7 | 9.15 | 8 | 7.68 |
| tbl_bmsql_order_line | ① | 1G | 359 | 45.23 | 361 | 22.32 | 515 | 10.71 |
| | ② | | 290 | 29.27 | 294 | 25.85 | 347 | 19.59 |
| | ③ | | 289 | 33.52 | 295 | 27.42 | 326 | 23.21 |
| tbl_bmsql_stock (a majority of random numbers) | ① | 1G | 691 | 32.79 | 693 | 9.19 | 909 | 4.57 |
| | ② | | 661 | 29.59 | 662 | 14.2 | 857 | 10.23 |
| | ③ | | 771 | 33.3 | 771 | 17.28 | 850 | 12.88 |
| tbl_bmsql_customer (a vast majority of random numbers) | ① | 1G | 695 | 29.12 | 698 | 8.63 | 893 | 4.52 |
| | ② | | 695 | 29.22 | 698 | 8.73 | 893 | 4.52 |
| | ③ | | 695 | 29.24 | 698 | 8.75 | 893 | 4.52 |

It can be learned from Table 11 to Table 16 that:

1. When the zstd general algorithm is used in S220 in the method 200, a lower compression level indicates shorter compression time consumed and a lower compression ratio.
2. More data pages compressed at a time indicate better compression performance. For example, if more data pages are compressed at a time, a compression ratio is higher and compression time consumed is shorter.

It can be learned from Table 16 that, in embodiments of this application, when the lz4 general algorithm used in S220 in the method 200 is compared with the zstd general algorithm used in S220 in the method 200, overall compression performance (a compression ratio and compression time consumed) in the embodiment using the lz4 general algorithm is lower than compression performance in the embodiment using the zstd general algorithm.

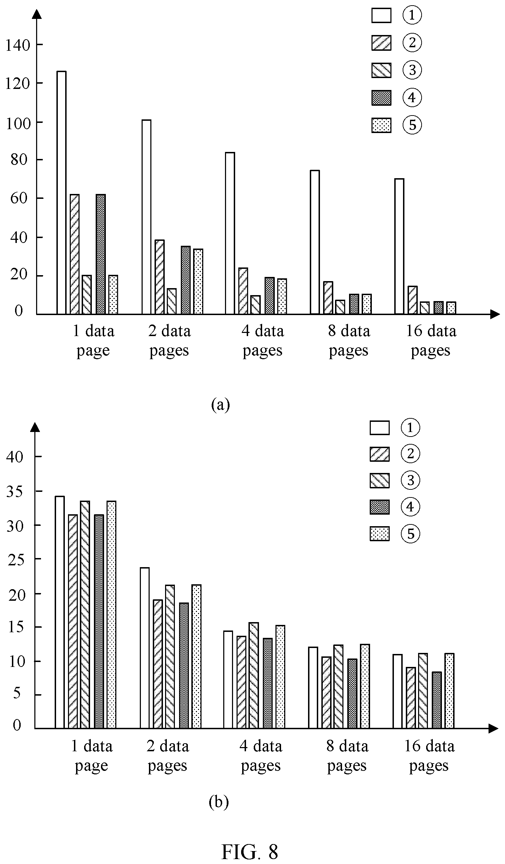

Compression performance of the data page compression method 200 and compression performance of the conventional compression method in a process of compressing data in the database GaussDB V3 by using the data page compression method 200 provided in embodiments of this application and the conventional compression method in Table 11 and Table 14 are described below in detail with reference to FIG. 8 to FIG. 11. For parts that are not described in Table 11 to Table 16, refer to the tables. Details are not described herein again.

It should be noted that FIG. 8 to FIG. 11 are merely used to compare compression performance of the processing manners ① to ⑤, and specific values are still subject to Table 11 to Table 16.

FIG. 8 to FIG. 11 are diagrams of four examples of compression performance according to an embodiment of this application.

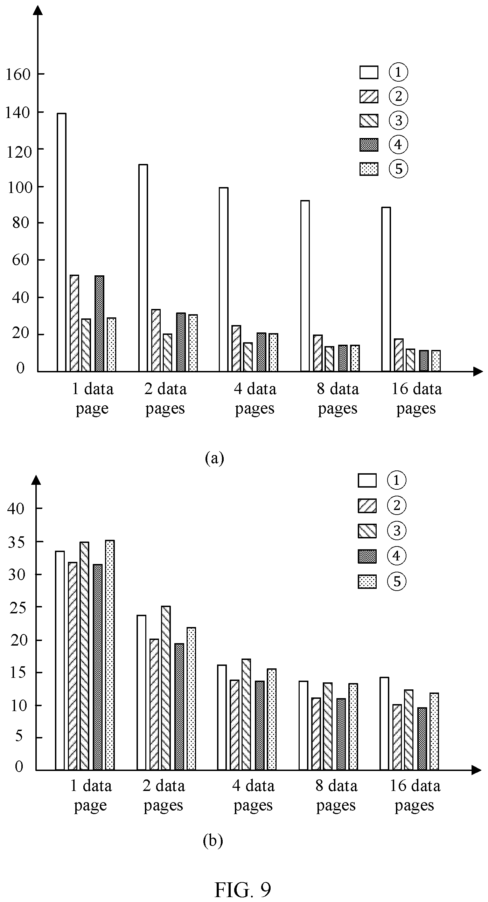

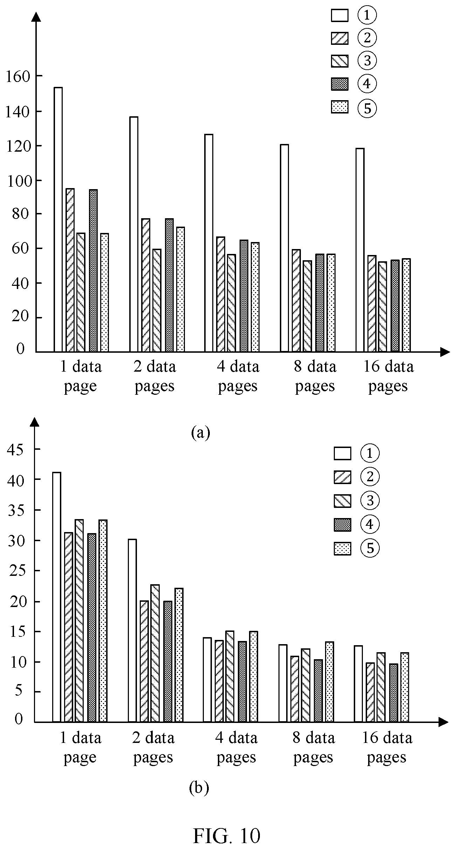

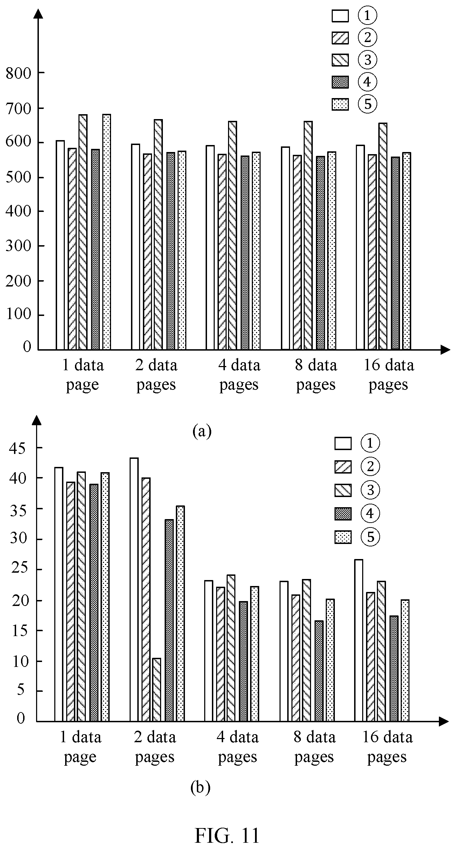

In figures shown in (a) in FIG. 8, (a) in FIG. 9, (a) in FIG. 10, and (a) in FIG. 11, a horizontal coordinate represents a quantity of data pages, and a vertical coordinate represents a size (unit: M (Megabyte)) of a compressed data page.

In figures shown in (b) in FIG. 8, (b) in FIG. 9, (b) in FIG. 10, and (b) in FIG. 11, a horizontal coordinate represents a quantity of data pages, and a vertical coordinate represents compression time consumed (unit: s (second)).

Similarities in FIG. 8 to FIG. 11 are as follows: 1. An example in which the zstd general algorithm is used in S220 in the method 200 is used. 2. Compression of 1 G (gigabyte) data is used as an example, and a compression level 9 is used as an example.

A difference between FIG. 8 to FIG. 11 lies in that index data idx_bmsql_oorder_pkey in the database GaussDB V3 is used as an example in FIG. 8, index data idx_bmsql_order_line_pkey in a database GaussDB V3 is used as an example in FIG. 9, table data tbl_bmsql_oorder in the database GaussDB V3 is used as an example in FIG. 10, and table data tbl_bmsql_stock in the database GaussDB V3 is used as an example in FIG. 11.

In one aspect, it can be learned from FIG. 8 to FIG. 10 that, before the data is compressed, different processing is performed on the data, and a size of a data page obtained through compression is different and compression time consumed is different. However, in general, regardless of index data or table data, a size of a data page obtained by compressing the data by using the data page compression method 200 provided in embodiments of this application is less than a size of a data page obtained by compressing the data by using the conventional compression method. In other words, a compression ratio of the data page compression method 200 provided in embodiments of this application is higher than a compression ratio of the conventional compression method. In another aspect, it can be learned from FIG. 8 to FIG. 11 that, time consumed in a compression process of the data page compression method 200 provided in embodiments of this application is almost the same as time consumed in compressing the data by using the conventional compression method. It can be learned that the data page compression method 200 provided in embodiments of this application has the higher compression ratio, and also consumes basically the same time as the conventional compression method.

In addition, because there are a large quantity of random numbers in the table data bmsql_order, when preprocessing performed on the table data bmsql_order includes differential processing, a size of a data page obtained by compressing the data by using the data page compression method 200 provided in embodiments of this application is greater than a size of a data page obtained by compressing the data by using the conventional compression method.

A data page compression process is described above. A data page decompression process is described below.

It should be understood that the data page compression process and the data page decompression process may be implemented separately or in combination. This is not limited in embodiments of this application.

It should be noted that the following uses an example in which a data page decompression process and a data page compression process are implemented in combination for description, and shall not constitute a limitation on this application.

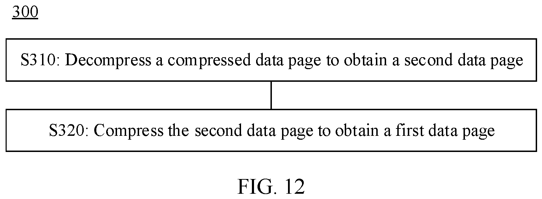

FIG. 12 is a schematic flowchart of an example of a data page decompression method 300 according to an embodiment of this application.

For example, as shown in FIG. 12, the method 300 includes S310 and S320, and S320 is performed after S310. S310 and S320 are described below in detail.

S310: Decompress a compressed data page to obtain a second data page.

A decompression method for decompressing the compressed data page is not limited in this embodiment of this application.

For example, the compressed data page may be decompressed by using a general decompression algorithm (for example, zlib, lz4, or zstd) to obtain the second data page.

S320: Obtain a first data page based on the second data page.

For a structure of the first data page, refer to the foregoing descriptions. Details are not described herein again.

The second data page may include a second row data part and a second directory part, where the second row data part is used to store second data, and the second directory part is used to store a second group of offsets.

In S320, first data in the first data page is data obtained by performing preprocessing on the second data in the second data page. First group of offsets in the first data page is a group of offsets obtained by performing the preprocessing on the second group of offsets in the second data page.

In one example, the preprocessing includes only byte-level-based row-column conversion.

In another example, the preprocessing not only includes byte-level-based row-column conversion, but also includes byte-level-based accumulation processing. The accumulation processing includes accumulation between column data.

It should be noted that the byte-level-based accumulation processing may be understood as accumulation performed by bytes.

In still another example, the preprocessing includes only accumulation processing.

For ease of description, a case in which the preprocessing includes only the byte-level-based row-column conversion is denoted as Case 1, a case in which the preprocessing includes not only the byte-level-based row-column conversion, but also includes the byte-level-based accumulation processing is denoted as Case 3, and a case in which the preprocessing includes only the accumulation processing is denoted as Case 4.

S320 is described in detail below by using examples when preprocessing is Case 1, Case 3, and Case 4 respectively.

Case 1: The preprocessing includes only the byte-level-based row-column conversion.

In Case 1, S320 specifically includes S321 to S324.

S321: Separately obtain the second data and the second group of offsets from the second data page.

For example, a start point and an end point of the second data and a start point and an end point of the offsets corresponding to the second data are first obtained from a second page head. Then, the second data is obtained from the second row data part in the second data page based on the start point and the end point of the second data, and the second group of offsets from the second directory part in the second data page is obtained based on the start point and the end point of the offsets corresponding to the second data.

For related descriptions of the start point and the end point, refer to the foregoing related descriptions. Details are not described herein again.

S322: Perform the preprocessing on the second group of offsets by bytes to obtain the first group of offsets.

Specifically, the preprocessing is performed on the second group of offsets by bytes based on a unit offset length of the second group of offsets, to obtain the first group of offsets.

A value of the unit offset length of the second group of offsets is not limited in this embodiment of this application. Descriptions are provided below by using an example in which the unit offset length of the second group of offsets is two bytes.

For example, the first group of offsets shown in Table 3 may be obtained by performing the byte-level-based row-column conversion on the second group of offsets shown in Table 6. For descriptions of Table 3 and Table 6, refer to the foregoing related descriptions. Details are not described herein again.

For another example, the first group of offsets shown in Table 4 may be obtained by performing the byte-level-based row-column conversion on the second group of offsets shown in Table 7. For descriptions of Table 4 and Table 7, refer to the foregoing related descriptions. Details are not described herein again.

S323: Perform the preprocessing on the second data by bytes based on the first group of offsets to obtain the first data.

Specifically, S323 includes the following steps.

S3231: Remove an invalid offset from the first group of offsets to obtain a fifth group of offsets, where the fifth group of offsets includes P offsets.

In an example, S3231 may be implemented based on information indicating the invalid offset.

If the information indicating the invalid offset indicates that (N-P) offsets are invalid, in this case, the (N-P) offsets need to be removed from the first group of offsets, to obtain the P valid offsets, namely, the fifth group of offsets.

A storage location of the information indicating the invalid offset is not limited in this embodiment of this application. For example, information indicating an invalid offset may be stored in the directory part, page head, or page tail in the second data page.

In another example, 3231 may be implemented based on each offset in the first group of offsets and the start point and the end point of the second data.

The start point and the end point of the second data may be obtained based on the page head or the page tail in the second data page.

Specifically, if P offsets in N offsets are between the start point and the end point of the second data, and (N-P) offsets are not between the start point and the end point of the second data, that is, P offsets in N offsets are valid, and (N-P) offsets are invalid,

In this example, the (N-P) offsets that are not between the start point and the end point of the second data need to be removed from the first group of offsets, to obtain the P valid offsets.

S3232: Arrange the P offsets in ascending order, to obtain the sorted P offsets.

For example, if the fifth group of offsets is shown in Table 3, the P offsets are sequentially 0x01, 0x04, and 0x08, and the P offsets are arranged in ascending order to obtain the sorted P offsets that are sequentially 0x01, 0x04, and 0x08.

For another example, if the fifth group of offsets is shown in Table 4, the P offsets are sequentially 0x06, 0x09, and 0x01, and the P offsets are arranged in ascending order to obtain the sorted P offsets that are sequentially 0x01, 0x06, and 0x09.

S3233: Create P regions based on the sorted P offsets, and obtain a length of each row of data in the first data, where the P regions one-to-one correspond to the P offsets.

The P offsets are in a one-to-one correspondence with the P regions. For example, an offset corresponding to a region ranked in a $k^{th}$ location in the P regions is a $k^{th}$ offset, and the $k^{th}$ offset is an offset ranked in a $k^{th}$ location in the P offsets in ascending order.

For example, if P=3, an offset corresponding to a region ranked in a first location in the three regions is an offset ranked in a first location in the three offsets shown in Table 3, namely, 0x01; an offset corresponding to a region ranked in a second location in the three regions is an offset ranked in a second location in the three offsets shown in Table 3, namely, 0x04; and an offset corresponding to a region ranked in a third location in the three regions is an offset ranked in a third location in the three offsets shown in Table 3, namely, 0x08.

For another example, if P=3, an offset corresponding to a region ranked in a first location in the three regions is an offset ranked in a third location in the three offsets shown in Table 4, namely, 0x01; an offset corresponding to a region ranked in a second location in the three regions is an offset ranked in a first location in the three offsets shown in Table 3, namely, 0x06; and an offset corresponding to a region ranked in a third location in the three regions is an offset ranked in a second location in the three offsets shown in Table 3, namely, 0x09.

A difference between a $(d+1)^{th}$ offset and a $d^{th}$ offset is used as a length of a $d^{th}$ row of data in the first data, where a value of d is sequentially obtained from 1 to (P-1); and a sum of 1 and a difference between a $P^{th}$ offset and the end point of the offsets of the first data is used as a length of a $P^{th}$ row of data in the first data.

For example, the three offsets shown in Table 3 are sequentially 0x01, 0x04, and 0x08 after being sorted; a difference between a second offset (0x04) and a first offset (0x01) is used as a length of the first row of data in the first data, that is, the length of the first row of data in the first data is (0x04-0x01)=0x03 (bytes); a difference between a third offset (0x08) and the second offset (0x04) is used as a length of the second row of data in the first data, that is, the length of the second row of data in the first data is (0x08-0x04)=0x04 (bytes); and a difference between an end point (for example, 0x0C) of the offsets of the first data and the third offset (0x08) is used as a length of the third row of data in the first data, that is, the length of the third row of data in the first data is (0x0C-0x08+0x01)=0x05 (bytes).

For another example, the three offsets shown in Table 4 are sequentially 0x01, 0x06, and 0x09 after being sorted; a difference between a second offset (0x06) and a first offset (0x01) is used as a length of the first row of data in the first data, that is, the length of the first row of data in the first data is (0x06-0x01)=0x05 (bytes); a difference between a third offset (0x09) and the second offset (0x06) is used as a length of the second row of data in the first data, that is, the length of the second row of data in the first data is (0x09-0x06)=0x03 (bytes); and a sum of 1 and a difference between an end point (for example, 0x0C) of the offsets of the first data and the third offset (0x09) is used as a length of the third row of data in the first data, that is, the length of the third row of data in the first data is (0x0C-0x09+0x01)=0x04 (bytes).

In this embodiment of this application, locations of the P regions are not limited, and whether the locations of the P regions are on the second data page or the first data page is not limited either.

Optionally, in some embodiments, before S3233 is performed, whether P is less than or equal to a fourth threshold may be first determined; and then S3233, S3234, and S324 are performed only when P is less than or equal to the fourth threshold. In this way, the byte-level-based row-column conversion is performed on the second data only when a quantity of rows of the first data is small, and a waste of resources can be avoided.

A specific value of the fourth threshold is not limited in this embodiment of this application, and may be set based on an actual situation.

A relationship between the fourth threshold and the second threshold is not limited in this embodiment of this application. For example, the fourth threshold may be equal to the second threshold.

S3234: Sequentially read, from the second row data part, data corresponding to R bytes, and sequentially store, into data corresponding to a byte q of an $s^{th}$ region in the P regions, data corresponding to a byte p in the R bytes, so as to complete a $q^{th}$ time of data reading/writing.

Herein, p is a positive integer, and a value of p is obtained from 1 to R.

R is a quantity of regions that are not fully written with data in the P regions. When the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data.

It should be noted that the $p^{th}$ offset may be understood as an offset in a $p^{th}$ location in an offset other than the offset corresponding to the region that is fully written with data in the fifth group of offsets.

Herein, a value of q is obtained from 1 to L2, and L2 is a maximum row length of the first data.

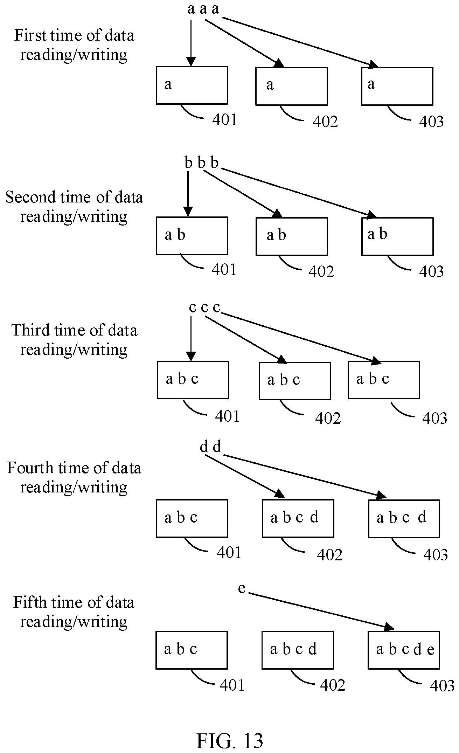

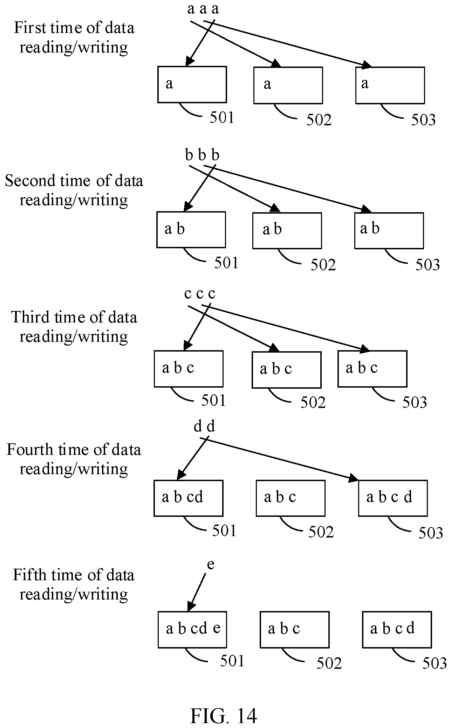

S3234 is described below in detail with reference to FIG. 13 and FIG. 14.

FIG. 13 is a diagram of an example of a second data reading/writing process according to this embodiment of this application. The second data in FIG. 13 is shown in Table 5, and the fifth group of offsets corresponding to the second data is shown in Table 3. P=3 in S3234. A region ranked in a first location in the three regions is a region 401, and an offset corresponding to the region 401 is an offset ranked in a first location in the three offsets shown in Table 3, namely, 0x01; a region ranked in a second location in the three regions is a region 402, and an offset corresponding to the region 402 is an offset ranked in a second location in the three offsets shown in Table 3, namely, 0x04; and a region ranked in a third location in the three regions is a region 403, and an offset corresponding to the region 403 is an offset ranked in a third location in the three offsets shown in Table 3, namely, 0x08. It can be seen that, in the example in FIG. 13, an arrangement order of the offsets corresponding to the three regions is an arrangement order of the three offsets shown in Table 3. The length of the first row of data in the first data=0x03 (bytes), the length of the second row of data in the first data is 0x04 (bytes), and the length of the third row of data in the first data is 0x05 (bytes).

As shown in FIG. 13, when q=1, because there are three regions that are not fully written with data in the three regions, R=3 in this case. Therefore, sequentially read data (aaa) corresponding to the three bytes from the second data shown in Table 5, and sequentially store data (a) corresponding to the byte 1 in the three bytes into data corresponding to a byte 1 of the region 401 (a region corresponding to the offset ranked in the first location in the three offsets shown in Table 3), data (a) corresponding to the byte 2 in the three bytes into data corresponding to a byte 1 of the region 402 (a region ranked in the second location in the three regions), and data (a) corresponding to the byte 3 in the three bytes into data corresponding to a byte 1 of the region 403 (a region ranked in the third location in the three regions), so as to complete a first time of data reading/writing.

When q=2, because there are three regions that are not fully written with data in the three regions, R=3 in this case. Therefore, sequentially read data (bbb) corresponding to the three bytes from the second data shown in Table 5, and sequentially store data (b) corresponding to the byte 1 in the three bytes into data corresponding to a byte 2 of the region 401 (a region corresponding to the offset ranked in the first location in the three offsets shown in Table 3), data (b) corresponding to the byte 2 in the three bytes into data corresponding to a byte 2 of the region 402 (a region corresponding to the offset ranked in the second location in the three offsets shown in Table 3), and data (b) corresponding to the byte 3 in the three bytes into data corresponding to a byte 2 of the region 403 (a region corresponding to the offset ranked in the third location in the three offsets shown in Table 3), so as to complete a second time of data reading/writing.

When q=3, because there are three regions that are not fully written with data in the three regions, R=3 in this case. Therefore, sequentially read data (ccc) corresponding to the three bytes from the second data shown in Table 5, and sequentially store data (c) corresponding to the byte 1 in the three bytes into data corresponding to a byte 3 of the region 401 (a region corresponding to the offset ranked in the first location in the three offsets shown in Table 3), data (c) corresponding to the byte 2 in the three bytes into data corresponding to a byte 3 of the region 402 (a region corresponding to the offset ranked in the second location in the three offsets shown in Table 3), and data (c) corresponding to the byte 3 in the three bytes into data corresponding to a byte 3 of the region 403 (a region corresponding to the offset ranked in the third location in the three offsets shown in Table 3), so as to complete a third time of data reading/writing.

After the third time of data reading/writing is completed, an amount (3 bytes) of data in the region 401, in the three regions, ranked in the first location in the three regions (the region corresponding to the offset ranked in the first location in the three offsets shown in Table 3) reaches the length (0x03) of the first row of data in the first data. In this case, it may be considered that the region 401 is fully written with data.

When q=4, because there are two regions that are not fully written with data in the three regions, R=2 in this case. In addition, the two regions that are not fully written with data include a region (the region 402), in the three regions, corresponding to an offset ranked in a first location in an offset except the offset ranked in the first location in the three offsets shown in Table 3, and a region (the region 403), in the three regions, corresponding to an offset ranked in a second location in an offset except the offset ranked in the first location in the three offsets shown in Table 3. Therefore, sequentially read data (dd) corresponding to the two bytes from the second data shown in Table 5, and sequentially store data (d) corresponding to the byte 1 in the two bytes into data corresponding to a byte 4 of the region 402, and data (d) corresponding to the byte 2 in the two bytes into data corresponding to a byte 4 of the region 403, so as to complete a fourth time of data reading/writing.

After the fourth time of data reading/writing is completed, an amount (4 bytes) of data in the region 402, in the three regions, ranked in the second location in the three regions (the region corresponding to the offset ranked in the second location in the three offsets shown in Table 3) reaches the length (0x04) of the second row of data in the first data. In this case, it may be considered that the region 402 is fully written with data.

When q=5, because there is one region that is not fully written with data in the three regions, R=1 in this case. In addition, the region that is not fully written with data is a region (the region 403) corresponding to an offset ranked in a first location in an offset other than the offset ranked in the first location and the offset ranked in the second location in the three offsets shown in Table 3. Therefore, read data (e) corresponding to the byte from the second data shown in Table 5, and store the data (e) corresponding to the byte into data corresponding to a byte 5 of the region 403 (the region that is not fully written with data), so as to complete a fifth time of data reading/writing.

After the foregoing five data reading/writing processes shown in FIG. 13 are performed, the second data may be read from the second data page, and the read second data is written into the three regions (the region 401, the region 402, and the region 403). In the three regions, data written into the region ranked in the first location in the three regions is abc, and the data occupies three bytes; in the three regions, data written into the region ranked in the second location in the three regions is abcd, and the data occupies four bytes; and in the three regions, data written into the region ranked in the third location in the three regions is abcde, and the data occupies five bytes.

FIG. 14 is a diagram of another example of a second data reading/writing process according to this embodiment of this application. The second data in FIG. 14 is shown in Table 5. The fifth group of offsets corresponding to the second data is shown in Table 4. In the fifth group of offsets, the offset ranked in the first location in the offsets is 0x06, the offset ranked in the second location is 0x09, and the offset ranked in the third location is 0x01. P=3 in S3234. A region ranked in a first location in the three regions is a region 501, and an offset corresponding to the region 501 is the offset ranked in the third location in the three offsets shown in Table 4, namely, 0x01; a region ranked in a second location in the three regions is a region 502, and an offset corresponding to the region 502 is an offset ranked in the first location in the three offsets shown in Table 3, namely, 0x06; and a region ranked in a third location in the three regions is a region 503, and an offset corresponding to the region 503 is an offset ranked in the second location in the three offsets shown in Table 3, namely, 0x09. It can be seen that, in the example in FIG. 14, an arrangement order of the offsets corresponding to the three regions is an arrangement order of the three offsets shown in Table 4 in ascending order. The length of the first row of data in the first data=0x05 (bytes), the length of the second row of data in the first data is 0x03 (bytes), and the length of the third row of data in the first data is 0x04 (bytes).

As shown in FIG. 14, when q=1, because there are three regions that are not fully written with data in the three regions, R=3 in this case. Therefore, sequentially read data (aaa) corresponding to the three bytes from the second data shown in Table 5, and sequentially store data (a) corresponding to the byte 1 in the three bytes into data corresponding to a byte 1 of the region 502 (a region corresponding to the offset ranked in the first location in the three offsets shown in Table 4), data (a) corresponding to the byte 2 in the three bytes into data corresponding to a byte 1 of the region 503 (a region corresponding to the offset ranked in the second location in the three offsets shown in Table 4), and data (a) corresponding to the byte 3 in the three bytes into data corresponding to a byte 1 of the region 501 (a region corresponding to the offset ranked in the third location in the three offsets shown in Table 4), so as to complete a first time of data reading/writing.

When q=2, because there are three regions that are not fully written with data in the three regions, R=3 in this case. Therefore, sequentially read data (bbb) corresponding to the three bytes from the second data shown in Table 5, and sequentially store data (b) corresponding to the byte 1 in the three bytes into data corresponding to a byte 2 of the region 502 (a region corresponding to the offset ranked in the first location in the three offsets shown in Table 4), data (b) corresponding to the byte 2 in the three bytes into data corresponding to a byte 2 of the region 503 (a region corresponding to the offset ranked in the second location in the three offsets shown in Table 4), and data (b) corresponding to the byte 3 in the three bytes into data corresponding to a byte 2 of the region 501 (a region corresponding to the offset ranked in the third location in the three offsets shown in Table 4), so as to complete a second time of data reading/writing.

When q=3, because there are three regions that are not fully written with data in the three regions, R=3 in this case. Therefore, sequentially read data (ccc) corresponding to the three bytes from the second data shown in Table 5, and sequentially store data (c) corresponding to the byte 1 in the three bytes into data corresponding to a byte 3 of the region 502 (a region corresponding to the offset ranked in the first location in the three offsets shown in Table 4), data (c) corresponding to the byte 2 in the three bytes into data corresponding to a byte 3 of the region 503 (a region corresponding to the offset ranked in the second location in the three offsets shown in Table 4), and data (c) corresponding to the byte 3 in the three bytes into data corresponding to a byte 3 of the region 501 (a region corresponding to the offset ranked in the third location in the three offsets shown in Table 4), so as to complete a third time of data reading/writing.

After the third time of data reading/writing is completed, an amount (3 bytes) of data in the region 502, in the three regions, ranked in the second location in the three regions (the region corresponding to the offset ranked in the first location in the three offsets shown in Table 4) reaches the length (0x03) of the second row of data in the first data. In this case, it may be considered that the region 502 is fully written with data.

When q=4, because there are two regions that are not fully written with data in the three regions, R=2 in this case. In addition, the two regions that are not fully written with data are a region (the region 503), in the three regions, corresponding to an offset ranked in a first location in an offset except the offset ranked in the first location in the three offsets shown in Table 4, and a region (the region 501), in the three regions, corresponding to an offset ranked in a second location in an offset except the offset ranked in the first location in the three offsets shown in Table 4. Therefore, sequentially read data (dd) corresponding to the two bytes from the second data shown in Table 5, and sequentially store data (d) corresponding to the byte 1 in the two bytes into data corresponding to a byte 4 of the region 503, and data (d) corresponding to the byte 2 in the two bytes into data corresponding to a byte 4 of the region 501, so as to complete a fourth time of data reading/writing.

After the fourth time of data reading/writing is completed, an amount (4 bytes) of data in the region 503, in the three regions, ranked in the third location in the three regions (the region corresponding to the offset ranked in the second location in the three offsets shown in Table 4) reaches the length (0x04) of the third row of data in the first data. In this case, it may be considered that the region 503 is fully written with data.

When q=5, because there is one region that is not fully written with data in the three regions, R=1 in this case. In addition, the region that is not fully written with data is a region (the region 501), in the three regions, corresponding to an offset ranked in a first location in an offset other than the offset ranked in the first location and the offset ranked in the second location in the three offsets shown in Table 4. Therefore, read data (e) corresponding to the byte from the second data shown in Table 5, and store the data (e) corresponding to the byte into data corresponding to a byte 5 of the region 501, so as to complete a fifth time of data reading/writing.

After the five data reading/writing processes shown in FIG. 14 are performed, the second data may be read from the second data page, and the read second data is written into the three regions (the region 501, the region 502, and the region 503). In the three regions, data written into the region ranked in the first location in the three regions is abcde, and the data occupies five bytes; in the three regions, data written into the region ranked in the second location in the three regions is abc, and the data occupies three bytes; and in the three regions, data written into the region ranked in the third location in the three regions is abcd, and the data occupies four bytes.

Optionally, in some embodiments, before S3234 is performed, whether a difference between lengths of the rows of data in the first data is less than or equal to a third threshold may be first determined, that is, S3235 is performed, and S3234 and S324 are performed only when the difference between the lengths of the rows of data in the first data is less than or equal to the third threshold. In this way, the byte-level-based row-column conversion is performed on the first data only when the difference between the lengths of the rows of data in the first data is small, and a waste of resources can be avoided.

A specific value of the third threshold is not limited in this embodiment of this application, and may be set based on an actual situation.

A relationship between the third threshold and the first threshold is not limited in this embodiment of this application. For example, the third threshold may be equal to the first threshold.

S324: Obtain the first data page based on the first data and the first group of offsets.

In an example, a data page may be created, and the first data and the first group of offsets are stored in the created data page, to form the first data page.

For example, a data page may be created, where the data page includes a first row data part and a first directory part, the first data is stored in the first row data part, and the first group of offsets is stored in the first directory part. In this way, the created data page is the first data page.

In another example, the first data page may be obtained based on the original second data page.

For example, the second data stored in the second row data part is updated to the first data, and the second group of offsets stored in the second directory part is updated to the first group of offsets, to obtain the first data page.

The updating the second data stored in the second row data part to the first data specifically includes sequentially overwriting the second data stored in the second row data part with the data in the P regions obtained in S3234.

For example, the data in the three regions shown in FIG. 13 is sequentially abcabcdabcde, that is, the second data is abcabcdabcde. For another example, the data in the three regions shown in FIG. 14 is sequentially abcdeabcabcd, that is, the second data is abcabcdabcde.

Case 3: The preprocessing includes the byte-level-based row-column conversion and the byte-level-based accumulation processing.

In Case 3, S320 specifically includes S321 to S324. Specific processes of S321 and S324 in Case 3 are the same as specific processes of S321 and S324 in Case 1, and details are not described herein again. Specific processes of S322 and S323 in Case 3 are different from specific processes of S322 and S323 in Case 1. The following describes in detail the specific processes of S322 and S323 in Case 3.

In Case 3, S322 specifically includes S322A and S322B.

S322A: Accumulate, by bytes, data in adjacent columns in a row c1 of the second group of offsets to obtain a third group of offsets.

$1 < c1 < c2$, both c1 and c2 are positive integers, and c2 is equal to a maximum row length of the second group of offsets or c2 is equal to a minimum row length of the second group of offsets.

For example, if the second group of offsets obtained in S321 is shown in Table 9, Table 6 shows an example of a

EP 4 510 002 A1

third group of offsets obtained by accumulating, by bytes, data in adjacent columns in a row c1 of the second group of offsets shown in Table 9. An example in which c2 is equal to a minimum row length (three bytes) of the second group of offsets is used.

For another example, if the second group of offsets obtained in S321 is shown in Table 10, Table 6 shows an example of a third group of offsets obtained by accumulating, by bytes, data in adjacent columns in a row c1 of the second group of offsets shown in Table 7. An example in which c2 is equal to a minimum row length (three bytes) of the second group of offsets is used.

S322B: Perform the row-column conversion on the third group of offsets by bytes to obtain the first group of offsets.

Specifically, the preprocessing is performed on the third group of offsets by bytes based on a unit offset length of the third group of offsets, to obtain the first group of offsets.

A value of the unit offset length of the third group of offsets is not limited in this embodiment of this application. Descriptions are provided below by using an example in which the unit offset length of the third group of offsets is two bytes.

For example, the first group of offsets shown in Table 3 may be obtained by performing the byte-level-based row-column conversion on the third group of offsets shown in Table 6. For descriptions of Table 3 and Table 6, refer to the foregoing related descriptions. Details are not described herein again.

For another example, the first group of offsets shown in Table 4 may be obtained by performing the byte-level-based row-column conversion on the third group of offsets shown in Table 7. For descriptions of Table 4 and Table 7, refer to the foregoing related descriptions. Details are not described herein again.

In Case 3, S323 specifically includes S323A and S323B.

S323A: Accumulate, by bytes, data in adjacent columns in a row d1 of the second data to obtain the third data.

$1 \leq d1 \leq d2$, both d1 and d2 are positive integers, and d2 is equal to a maximum row length of the second data or d2 is equal to a minimum row length of the second data.

For example, if the second data obtained in S321 is shown in Table 8, Table 5 shows an example of third data obtained by accumulating, by bytes, data in adjacent columns in a row c1 of the second data shown in Table 8. An example in which d2 is equal to a minimum row length (three bytes) of the second data is used.

S323B: Perform the row-column conversion on the third data by bytes based on the first group of offsets to obtain the first data.

Specifically, S323B includes S3231 to S3233 and S3234A. For descriptions of S3231 to S3233, refer to the foregoing related descriptions. Details are not described herein again. S3234A is focused on herein.

S3234A: Sequentially read, from the third data, data corresponding to R bytes, and sequentially store, into data corresponding to a byte q of an $s^{th}$ region in the P regions, data corresponding to a byte p in the R bytes, so as to complete a $q^{th}$ time of data reading/writing.

Herein, p is a positive integer, and a value of p is obtained from 1 to R.

R is a quantity of regions that are not fully written with data in the P regions. When the $s^{th}$ region is fully written with data, an amount of data in the $s^{th}$ region is a length of an $s^{th}$ row of data in the first data, s is a positive integer, an offset corresponding to the $s^{th}$ region is an $s^{th}$ offset, and the $s^{th}$ offset is a $p^{th}$ offset in an offset in the fifth group of offsets other than an offset corresponding to a region that is fully written with data.

Herein, a value of q is obtained from 1 to L2, and L2 is a maximum row length of the first data.

Based on the foregoing descriptions of S3234A, it can be learned that a process of S3234A is similar to that of S3234 described above. A difference between S3234A and S3234 lies in that: In S3234A, the data corresponding to the R bytes is read from the third data, while in S3234, the data corresponding to the R bytes is read from the second row data part, namely, the second data. Therefore, for detailed descriptions of S3234A, refer to the related descriptions of S3234. Details are not described herein again.

Case 4: The preprocessing includes only the byte-level-based accumulation processing.

In Case 4, S320 specifically includes S321 to S324. Specific processes of S321 and S324 in Case 4 are the same as specific processes of S321 and S324 in Case 3, and details are not described herein again. Specific processes of S322 and S323 in Case 4 are different from specific processes of S322 and S323 in Case 3. The following describes in detail the specific processes of S322 and S323 in Case 4.

In Case 4, S322 specifically includes: Accumulate, by bytes, data in adjacent columns in a row g1 of the second group of offsets to obtain the first group of offsets.

$1 \leq g1 \leq c2$, and g1 is a positive integer. For c2, refer to the foregoing related descriptions.

In Case 4, a specific process of S322 is similar to a process of S322A in Case 3. For the specific process of S322 in Case 4, refer to corresponding descriptions of S322A in Case 3. Details are not described herein again.

In Case 4, S323 specifically includes: Accumulate, by bytes, data in adjacent columns in a row h1 of the second data to obtain the first data.

$1 \leq h1 \leq d2$, and h1 is a positive integer. For d2, refer to the foregoing related descriptions.

In Case 4, a specific process of S323 is similar to a process of S323A in Case 3. For the specific process of S323 in Case 4, refer to corresponding descriptions of S323A in Case 3. Details are not described herein again.

Optionally, in some embodiments, if the first data page is obtained by reorganizing a plurality of data pages, the first data page further needs to be split to obtain the plurality of data pages.

Optionally, in some embodiments, the first data page includes information indicating that the reorganization is performed on the first data page. In this way, whether the first data page has been reorganized may be learned of by using the first data page.

For descriptions of the information indicating that the reorganization is performed on the first data page, refer to the foregoing related descriptions. Details are not described herein again.

That is, after S320, the method 300 may further include the following step.

S330: Split the first data page to obtain a plurality of third data pages.

For descriptions of the first data page and the third data page in S330, refer to the foregoing related descriptions. Details are not described herein again.

Specifically, S330 includes the following steps. S331: Obtain start points and end points of fourth data and start points and end points of fourth groups of offsets in the plurality of third data pages based on the page head in the first data page.

Optionally, in some embodiments, if a data page further includes a page head and/or a page tail in addition to a row data part and a directory part, in a process of performing S331, the following steps further need to be performed: First, separately obtain data stored in a plurality of page heads corresponding to the plurality of third data pages and/or data stored in a plurality of page tails corresponding to the plurality of third data pages. Then, separately split the data stored in the plurality of page heads and/or the data stored in the plurality of page tails in a target sequence, to obtain the data stored in the page heads in the plurality of third data pages and/or the data stored in the page tails in the plurality of third data pages, and separately store the data stored in the page heads in the plurality of third data pages and/or the data stored in the page tails in the plurality of third data pages in the page heads in the plurality of third data pages and/or the page tails in the plurality of third data pages. Finally, obtain a start point and an end point of fourth data and a start point and an end point of a fourth group of offsets corresponding to each third data page based on data stored in a page head of each third data page and/or data stored in a page tail of each third data page.

S332: Obtain a plurality of pieces of fourth data from the first data page based on the start points and the end points of the plurality of pieces of fourth data, and obtain a plurality of fourth groups of offsets from the first data page based on the start points and the end points of the plurality of fourth groups of offsets.

In this embodiment of this application, a sequence of performing steps of obtaining the fourth data and obtaining the fourth group of offsets in S332 is not limited. For example, the fourth data may be obtained before the fourth group of offsets, or the fourth data may be obtained after the fourth group of offsets, or both the fourth data and the fourth group of offsets may be obtained at the same time.

S333: Separately store the plurality of pieces of fourth data and the plurality of fourth groups of offsets into the plurality of third data pages.

In the method 300 described above, because the rows of data stored in the second data page are similar, repetitive, and regular, a decompression ratio of decompressing the second data page is high. This improves a decompression ratio of a data page. In addition, decompression time consumed in embodiments of this application is basically the same as that in the conventional decompression method.

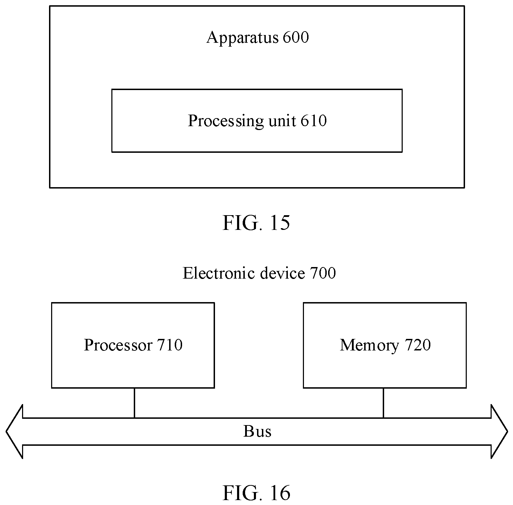

Data page processing apparatuses provided in embodiments of this application are described with reference to FIG. 15 and FIG. 16.

FIG. 15 is a block diagram of a data page processing apparatus according to an embodiment of this application.

As shown in FIG. 15, the apparatus 600 includes a processing unit 610.

In an implementation, the processing unit 610 is configured to implement the steps described in the foregoing method 200. Details are not described herein again.

In another possible implementation, the processing unit 610 is configured to implement the steps described in the foregoing method 300. Details are not described herein again.

FIG. 16 is a diagram of a structure of an example of another data page processing apparatus according to an embodiment of this application.

As shown in FIG. 16, the data page processing apparatus 700 includes one or more processors 710 and one or more memories 720. The one or more memories 720 store one or more computer programs, and the one or more computer programs include instructions. When the instructions are run by the one or more processors 710, the data page processing apparatus is enabled to perform the steps in the method 200 or method 300.

An embodiment of this application provides a computer program product. When the computer program product runs on a data page processing apparatus, the data page processing apparatus is enabled to perform the steps in the method 200 or method 300. An implementation principle and technical effect thereof are similar to those of the foregoing method-related embodiment. Details are not described herein again.

An embodiment of this application provides a readable storage medium. The readable storage medium includes instructions. When the instructions are run on a data page processing apparatus, the data page processing apparatus is enabled to perform the steps in the method 200 or method 300. An implementation principle and technical effect thereof are similar. Details are not described herein again.

An embodiment of this application provides a readable storage medium. The readable storage medium includes instructions. When the instructions are run on a data page processing apparatus, the data page processing apparatus is enabled to perform the steps in the method 200 or method 300. An implementation principle and technical effect thereof are similar. Details are not described herein again.

An embodiment of this application provides a chip system, including a processor, configured to invoke a computer program from a memory and run the computer program, so that an apparatus on which the chip system is installed performs the steps in the method 200 or method 300. An implementation principle and technical effect thereof are similar. Details are not described herein again.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data page processing method, comprising:

   obtaining a second data page based on a first data page; and
   compressing the second data page to obtain a compressed data page, wherein
   the first data page comprises first data stored in a row-based manner and a first group of offsets, and the first group of offsets indicates an offset of each row of data in the first data; and
   the second data page comprises second data stored in a row-based manner and a second group of offsets, the second group of offsets indicates an offset of each row of data in the second data, the second data is data obtained by performing preprocessing on the first data, the second group of offsets is a group of offsets obtained by performing the preprocessing on the first group of offsets, and the preprocessing comprises byte-level-based row-column conversion.

2. The method according to claim 1, wherein the obtaining a second data page based on a first data page comprises:

separately obtaining the first data and the first group of offsets from the first data page;
performing the preprocessing on the first data by bytes to obtain the second data;
performing the preprocessing on the first group of offsets by bytes to obtain the second group of offsets; and
obtaining the second data page based on the second data and the second group of offsets.

3. The method according to claim 2, wherein the first data page comprises a first row data part and a first directory part, the first row data part is used to store the first data, and the first directory part is used to store the first group of offsets; and

the obtaining the second data page based on the second data and the second group of offsets comprises:
updating the first data stored in the first row data part to the second data, and updating the first group of offsets stored in the first directory part to the second group of offsets, to obtain the second data page.

4. The method according to claim 2 or 3, wherein the preprocessing further comprises byte-level-based differential processing, and the differential processing comprises differential processing between column data.

5. The method according to claim 4, wherein
the performing the preprocessing on the first data by bytes to obtain the second data comprises:

performing the row-column conversion on the first data by bytes to obtain third data; and
performing differential processing on data in adjacent columns in a row $a1$ of the third data by bytes to obtain the second data, wherein $1 \leq a1 \leq a2$, both $a1$ and $a2$ are positive integers, and $a2$ is equal to a maximum row length of the first data or $a2$ is equal to a minimum row length of the first data; and
the performing the preprocessing on the first group of offsets by bytes to obtain the second group of offsets comprises:
performing the row-column conversion on the first group of offsets by bytes to obtain a third group of offsets; and
performing differential processing on data in adjacent columns in a row $b1$ of the third group of offsets by bytes to obtain the second group of offsets, wherein $1 \leq b1 \leq b2$, both $b1$ and $b2$ are positive integers, and $b2$ is equal to a maximum row length of the first group of offsets or $b2$ is equal to a minimum row length of the first group of offsets.

6. The method according to any one of claims 1 to 5, wherein the method further comprises:

reorganizing a plurality of consecutive third data pages of a same structure to obtain the first data page, wherein the third data page comprises fourth data stored in a row-based manner and a fourth group of offsets, the fourth group of offsets indicates an offset of each row of data in the fourth data, the first data comprises a plurality of pieces of fourth data corresponding to the plurality of third data pages, maximum row lengths of the plurality of pieces of fourth data are the same, and the first group of offsets comprises a plurality of fourth groups of offsets corresponding to the plurality of third data pages.

7. The method according to claim 6, wherein
the reorganizing a plurality of consecutive third data pages of a same structure to obtain the first data page comprises:

separately obtaining the plurality of pieces of fourth data and the plurality of fourth groups of offsets that correspond to the plurality of third data pages;
separately arranging the plurality of pieces of fourth data in a target order to obtain the first data, and separately arranging the plurality of fourth groups of offsets in the target order to obtain the first group of offsets, wherein the target order is an arrangement order of the plurality of third data pages; and
separately storing the first data and the first group of offsets into the first data page.

8. The method according to claim 6 or 7, wherein the first data page comprises information indicating that reorganization is performed on the first data page.

9. The method according to any one of claims 1 to 8, wherein the second data page comprises information indicating that the preprocessing is performed on the second data page.

10. The method according to any one of claims 1 to 9, wherein the method further comprises:

decompressing the compressed data page to obtain the second data page; and
obtaining the first data page based on the second data page, wherein the first data is data obtained by performing the preprocessing on the second data, and the first group of offsets is a group of offsets obtained by performing the preprocessing on the second group of offsets.

11. The method according to claim 10, wherein the obtaining the first data page based on the second data page comprises:

separately obtaining the second data and the second group of offsets from the second data page;
performing the preprocessing on the second group of offsets by bytes to obtain the first group of offsets;
performing the preprocessing on the second data by bytes based on the first group of offsets to obtain the first data; and
obtaining the first data page based on the first data and the first group of offsets.

12. The method according to claim 11, wherein the second data page comprises a second row data part and a second directory part, the second row data part is used to store the second data, and the second directory part is used to store the second group of offsets; and
the obtaining the first data page based on the first data and the first group of offsets comprises:
updating the second data stored in the second row data part to the first data, and updating the second group of offsets stored in the second directory part to the first group of offsets, to obtain the first data page.

13. The method according to claim 11 or 12, wherein the preprocessing further comprises byte-level-based accumulation processing, and the accumulation processing comprises accumulation between column data.

14. The method according to claim 13, wherein
the performing the preprocessing on the second group of offsets by bytes to obtain the first group of offsets comprises:

accumulating data in adjacent columns in a row c1 of the second group of offsets by bytes to obtain a third group of offsets, wherein $1 \leq c1 \leq c2$, both c1 and c2 are positive integers, and c2 is equal to a maximum row length of the second group of offsets or c2 is equal to a minimum row length of the second group of offsets; and
performing the row-column conversion on the third group of offsets by bytes to obtain the first group of offsets; and
the performing the preprocessing on the second data by bytes based on the first group of offsets to obtain the first data comprises:

accumulating data in adjacent columns in a row d1 of the second data by bytes to obtain the third data, wherein $1 \leq d1 \leq d2$, both d1 and d2 are positive integers, and d2 is equal to a maximum row length of the second data or d2 is equal to a minimum row length of the second data; and
performing the row-column conversion on the third data by bytes based on the first group of offsets to obtain the first data.

15. The method according to any one of claims 1 to 14, wherein the method further comprises:
splitting the first data page to obtain the plurality of third data pages.

16. The method according to claim 15, wherein
the splitting the first data page to obtain the plurality of third data pages comprises:

obtaining start points and end points of fourth data in the plurality of third data pages and start points and end points of the fourth groups of offsets in the plurality of third data pages;
obtaining the plurality of pieces of fourth data from the first data page based on the start points and the end points of the plurality of pieces of fourth data, and obtaining the plurality of fourth groups of offsets from the first data page based on the start points and the end points of the plurality of fourth groups of offsets; and
separately storing the plurality of pieces of fourth data and the plurality of fourth groups of offsets into the plurality of third data pages.

17. The method according to claim 15 or 16, wherein the first data page comprises the information indicating that the reorganization is performed on the first data page.

18. A data page processing apparatus, wherein the apparatus comprises a processing unit, and the processing unit is configured to:

obtain a second data page based on a first data page; and
compress the second data page to obtain a compressed data page, wherein
the first data page comprises first data stored in a row-based manner and a first group of offsets, and the first group of offsets indicates an offset of each row of data in the first data; and
the second data page comprises second data stored in a row-based manner and a second group of offsets, the second group of offsets indicates an offset of each row of data in the second data, the second data is data obtained by performing preprocessing on the first data, the second group of offsets is a group of offsets obtained by performing the preprocessing on the first group of offsets, and the preprocessing comprises byte-level-based row-column conversion.

19. The apparatus according to claim 18, wherein the processing unit is further specifically configured to:

separately obtain the first data and the first group of offsets from the first data page;
perform the preprocessing on the first data by bytes to obtain the second data;
perform the preprocessing on the first group of offsets by bytes to obtain the second group of offsets; and
obtain the second data page based on the second data and the second group of offsets.

20. The apparatus according to claim 18 or 19, wherein the preprocessing further comprises byte-level-based differential processing, and the differential processing comprises differential processing between column data.

21. The apparatus according to any one of claims 18 to 20, wherein the processing unit is further configured to:

reorganize a plurality of consecutive third data pages of a same structure to obtain the first data page, wherein the third data page comprises fourth data stored in a row-based manner and a fourth group of offsets, the fourth group of offsets indicates an offset of each row of data in the fourth data, the first data comprises a plurality of pieces of fourth data corresponding to the plurality of third data pages, maximum row lengths of the plurality of pieces of fourth data are the same, and the first group of offsets comprises a plurality of fourth groups of offsets corresponding to the plurality of third data pages.

22. The apparatus according to any one of claims 18 to 21, wherein the processing unit is further configured to:

decompress the compressed data page to obtain the second data page; and
obtain the first data page based on the second data page, wherein the first data is data obtained by performing the preprocessing on the second data, and the first group of offsets is a group of offsets obtained by performing the preprocessing on the second group of offsets.

23. The apparatus according to any one of claims 18 to 22, wherein the processing unit is further configured to:
split the first data page to obtain the plurality of third data pages.

24. A data page processing apparatus, wherein the apparatus comprises a processor and a memory, the memory is configured to store a computer program, and the processor is configured to execute the computer program stored in the memory, so that the apparatus performs the method according to any one of claims 1 to 17.

25. A computer-readable storage medium, wherein the computer-readable storage medium stores a computer program, and when the computer program is run on a computer, the computer is enabled to perform the method according to any one of claims 1 to 17.

26. A chip system, comprising a processor, configured to invoke a computer program from a memory and run the computer program, to enable an apparatus on which the chip system is installed to perform the method according to any one of claims 1 to 17.

<u>200</u>

| S210: Obtain a second data page based on a first data page |
|---|

| S220: Compress the second data page to obtain a compressed data page |
|---|

FIG. 1

| Page head |
|---|
| Row data part |
| Free space |
| Directory part |
| Page tail |

FIG. 2

<u>S210</u>

| S211: Separately obtain first data and a first group of offsets from a first data page |
|---|

| S211: Perform preprocessing on the first data by bytes to obtain second data |
|---|

| S213: Perform preprocessing on the first group of offsets by bytes to obtain a second group of offsets |
|---|

| S214: Obtain a second data page based on the second data and the second group of offsets |
|---|

FIG. 3

S212

S2121: Obtain, based on a start point and an end point of offsets of first data and a unit offset length of a first group of offsets, a quantity M of offsets included in the first group of offsets

S2122: Remove an invalid offset from the M offsets to obtain N offsets, where N is less than or equal to M, and both N and M are positive integers

S2123: Arrange the N offsets in ascending order to obtain the sorted N offsets

S2124: Divide a first row data part into N regions based on the sorted N offsets, and obtain a length of each row of data of the first data

S2125: Sequentially obtain, in an arrangement order of the N offsets from the N regions, data corresponding to a byte i as data in a row i and a column N of second data, where a value of i is sequentially obtained from 1 to L1, i is a positive integer, L1 is a maximum row length of the first data, and the arrangement order of the N offsets is the ascending order of the N offsets or an arrangement order of the N offsets in the first group of offsets

FIG. 4

S212

S212A: Perform row-column conversion on first data by bytes to obtain third data

S212B: Perform differential processing on data in adjacent columns in a row a1 of the third data by bytes to obtain second data, where 1≤a1≤a2, both a1 and a2 are positive integers, and a2 is equal to a maximum row length of the first data or a2 is equal to a minimum row length of the first data

FIG. 5

S213

| S213A: Perform row-column conversion on a first group of offsets by bytes to obtain a third group of offsets |
|---|

| S213B: Perform differential processing on data in adjacent columns in a row b1 of the third group of offsets by bytes to obtain a second group of offsets, where $1 \leq b1 \leq b2$, both b1 and b2 are positive integers, and b2 is equal to a maximum row length of the first group of offsets or b2 is equal to a minimum row length of the first group of offsets |
|---|

FIG. 6

EP 4 510 002 A1

| 10 | 20 | 30 | 40 | 50 | 60 | 70 |
|---|---|---|---|---|---|---|
| Convertible Maximum row length=40 | Convertible Maximum row length=50 | Convertible Maximum row length=50 | Inconvertible Maximum row length=50 | Convertible Maximum row length=50 | Convertible Maximum row length=60 | Convertible Maximum row length=60 |

| 10 | 20-30 | 40 | 50 | 60-70 |
|---|---|---|---|---|
| Convertible Maximum row length=40 | Reorganized page Maximum row length=50 | Inconvertible Maximum row length=50 | Convertible Maximum row length=50 | Reorganized page Maximum row length=60 |

FIG. 7

(a)

(b)

FIG. 8

(a)

(b)

FIG. 9

(a)

(b)

FIG. 10

FIG. 11

<u>300</u>

| S310: Decompress a compressed data page to obtain a second data page |
| --- |

| S320: Compress the second data page to obtain a first data page |
| --- |

FIG. 12

First time of data
reading/writing

a a a

a          a          a

401        402        403

Second time of data
reading/writing

b b b

a b        a b        a b

401        402        403

Third time of data
reading/writing

c c c

a b c      a b c      a b c

401        402        403

Fourth time of data
reading/writing

d d

a b c      a b c d    a b c d

401        402        403

Fifth time of data
reading/writing

e

a b c      a b c d    a b c d e

401        402        403

FIG. 13

First time of data
reading/writing

a a a

| a | | a | | a |

501     502     503

Second time of data
reading/writing

b b b

| a b | | a b | | a b |

501     502     503

Third time of data
reading/writing

c c c

| a b c | | a b c | | a b c |

501     502     503

Fourth time of data
reading/writing

d d

| a b cd | | a b c | | a b c d |

501     502     503

Fifth time of data
reading/writing

e

| a b cd e | | a b c | | a b c d |

501     502     503

FIG. 14

Apparatus 600

Processing unit 610

FIG. 15

Electronic device 700

Processor 710

Memory 720

Bus

FIG. 16

# EP 4 510 002 A1

**INTERNATIONAL SEARCH REPORT**

| International application No. |
|---|
| **PCT/CN2022/137287** |

**A. CLASSIFICATION OF SUBJECT MATTER**

G06F16/22(2019.01)i;H03M7/30(2006.01)n

According to International Patent Classification (IPC) or to both national classification and IPC

**B. FIELDS SEARCHED**

Minimum documentation searched (classification system followed by classification symbols)

IPC: G06F, H03M

Documentation searched other than minimum documentation to the extent that such documents are included in the fields searched

Electronic data base consulted during the international search (name of data base and, where practicable, search terms used)

CNTXT, ENTXTC, CNKI, ISI, IEEE, Bing, baidu: 列, 行, 存储, 转换, 变换, 转化, 差分, 累加, 求和, 相加, 压缩, 率, 字节, column, row, store, convert, transform, difference, accumulate, sum, add, compression, rate, ratio, byte

**C. DOCUMENTS CONSIDERED TO BE RELEVANT**

| Category* | Citation of document, with indication, where appropriate, of the relevant passages | Relevant to claim No. |
|---|---|---|
| Y | US 8239421 B1 (ORACLE INTERNATIONAL CORP.) 07 August 2012 (2012-08-07) description, column 7, line 62-column 8, line 51 | 4, 5, 20 |
| A | JP 2012004636 A (YOKOGAWA ELECTRIC CORP.) 05 January 2012 (2012-01-05) entire document | 1-26 |
| A | US 2015178305 A1 (MUELLER, Ingo et al.) 25 June 2015 (2015-06-25) entire document | 1-26 |
| A | CN 113220651 A (JINAN UNIVERSITY) 06 August 2021 (2021-08-06) entire document | 1-26 |
| A | CN 110990402 A (ZHONGKE YUSUR (BEIJING) TECHNOLOGY CO., LTD.) 10 April 2020 (2020-04-10) | |
| X | QIAO, Yifan et al. "Improving Relational Database Upon the Arrival of Storage Hardware with Built-in Transparent Compression" *2021 IEEE International Conference on Networking, Architecture and Storage (NAS),* 22 November 2021 (2021-11-22), sections 1 and 3 | 1-3, 6-12, 15-19, 21-26 |

☑ Further documents are listed in the continuation of Box C. ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 February 2023** | **22 February 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

57

**INTERNATIONAL SEARCH REPORT**

| International application No. |
|---|
| **PCT/CN2022/137287** |

**C.    DOCUMENTS CONSIDERED TO BE RELEVANT**

| Category* | Citation of document, with indication, where appropriate, of the relevant passages | Relevant to claim No. |
|---|---|---|
| Y | QIAO, Yifan et al. "Improving Relational Database Upon the Arrival of Storage Hardware with Built-in Transparent Compression" *2021 IEEE International Conference on Networking, Architecture and Storage (NAS),* 22 November 2021 (2021-11-22), sections 1 and 3 | 4, 5, 20 |

Form PCT/ISA/210 (second sheet) (July 2022)

| INTERNATIONAL SEARCH REPORT | | | International application No. |
| --- | --- | --- | --- |
| Information on patent family members | | | **PCT/CN2022/137287** |

| Patent document cited in search report | | | Publication date (day/month/year) | Patent family member(s) | | | Publication date (day/month/year) |
| --- | --- | --- | --- | --- | --- | --- | --- |
| US | 8239421 | B1 | 07 August 2012 | None | | | |
| JP | 2012004636 | A | 05 January 2012 | None | | | |
| US | 2015178305 | A1 | 25 June 2015 | EP | 2889787 | A2 | 01 July 2015 |
| | | | | EP | 2889787 | A3 | 05 August 2015 |
| | | | | EP | 2889787 | B1 | 05 December 2018 |
| | | | | US | 2019155788 | A1 | 23 May 2019 |
| | | | | US | 10824596 | B2 | 03 November 2020 |
| | | | | US | 10235377 | B2 | 19 March 2019 |
| CN | 113220651 | A | 06 August 2021 | None | | | |
| CN | 110990402 | A | 10 April 2020 | None | | | |

Form PCT/ISA/210 (patent family annex) (July 2022)

**EP 4 510 002 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2022112514